(19) Europäisches Patentamt
European Patent Office
Office européen des brevets

(11) EP 3 778 217 A1

(12) EUROPEAN PATENT APPLICATION
published in accordance with Art. 153(4) EPC

(43) Date of publication:
17.02.2021 Bulletin 2021/07

(51) Int Cl.:
B32B 9/00 (2006.01)     B32B 27/20 (2006.01)
H01L 51/50 (2006.01)     H05B 33/02 (2006.01)
H05B 33/04 (2006.01)

(21) Application number: 19776477.2

(22) Date of filing: 22.03.2019

(86) International application number:
PCT/JP2019/012052

(87) International publication number:
WO 2019/188771 (03.10.2019 Gazette 2019/40)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 27.03.2018  JP 2018060328

(71) Applicant: SUMITOMO CHEMICAL COMPANY,
LIMITED
Chuo-ku
Tokyo 104-8260 (JP)

(72) Inventors:
• YAMASHITA, Yasuhiro
Niihama-shi, Ehime 792-0015 (JP)
• HANAOKA, Hidenori
Osaka-shi, Osaka 554-8558 (JP)
• YAMAKAWA, Shohei
Niihama-shi, Ehime 792-0015 (JP)

(74) Representative: J A Kemp LLP
14 South Square
Gray's Inn
London WC1R 5JJ (GB)

(54) LAMINATE FILM

(57) An object of the present invention is to provide a laminate film excellent in heat resistance. The present invention relates to a laminate film including: a second primer layer, a flexible substrate, a first primer layer, a first organic layer, and a first inorganic thin film layer in this order, in which the first primer layer and the second primer layer each have a softening temperature of 130°C or higher; when a thermal expansion displacement in the MD is defined as A ($\mu$m) and a heating temperature is defined as T (°C) when the laminate film is heated while being pulled at a tensile load of 29.4 mN and a temperature elevation rate of 20°C/min, the laminate film constantly satisfies a relationship $dA/dT > 0$ where T is 50 to 200°C; and a dimensional change rate in the MD when the laminate film is heated from 25°C to 200°C, left to stand at 200°C for 20 minutes, and cooled to 25°C is -0.3 to 0.5%.

EP 3 778 217 A1

**Description**

TECHNICAL FIELD

The present invention relates to a laminate film including a second primer layer, a flexible substrate, a first primer layer, a first organic layer, and a first inorganic thin film layer in this order, and a flexible electronic device including the laminate film.

BACKGROUND ART

Laminate films to which gas barrier properties are imparted have been widely used for applications such as packages for foods, industrial products, pharmaceuticals, and the like. In recent years, in flexible substrates of electronic devices such as solar cells and organic EL displays, laminate films with further improved gas barrier properties compared to those for food application or the like have been demanded. To enhance gas barrier properties and the like of such a laminate film, a laminate film, in which a thin film layer is laminated on a flexible substrate made of polyethylene terephthalate (PET) through an organic layer, has been studied (for example, Patent Document 1).

PRIOR ART DOCUMENTS

PATENT DOCUMENTS

Patent Document 1: JP-A-2016-68383

SUMMARY OF THE INVENTION

PROBLEMS TO BE SOLVED BY THE INVENTION

However, according to the study by the present inventor, it is found that the heat resistance of such a laminate film is not necessarily sufficient, and for example, when the laminate film is exposed in a high temperature environment and cooled to room temperature, problems such as generation of cracks arise in some cases.
It is therefore an object of the present invention is to provide a laminate film excellent in heat resistance and a flexible electronic device including the laminate film.

MEANS FOR SOLVING THE PROBLEMS

As a result of intensive studies to solve the above-described problems, the present inventor found that the above-described problems can be solved by a laminate film including a second primer layer, a flexible substrate, a first primer layer, a first organic layer, and a first inorganic thin film layer in this order, in which the first primer layer and the second primer layer each have a softening temperature of 130°C or higher; the thermal expansion displacement A ($\mu$m) and the heating temperature T (°C) satisfies a relationship dA/dT > 0 where (T) is 50 to 200°C; and the dimensional change rate in the MD is -0.3 to 0.5%, and completed the present invention. That is, the present invention includes the following features.

[1] A laminate film, including: a second primer layer, a flexible substrate, a first primer layer, a first organic layer, and a first inorganic thin film layer in this order, in which
the first primer layer and the second primer layer each have a softening temperature of 130°C or higher;
when a thermal expansion displacement in an MD is defined as A ($\mu$m) and a heating temperature is defined as T (°C) when the laminate film is heated while being pulled at a tensile load of 29.4 mN and a temperature elevation rate of 20°C/min,
the laminate film constantly satisfies a relationship dA/dT > 0 where T is 50 to 200°C; and
a dimensional change rate in the MD when the laminate film is heated from 25°C to 200°C, left to stand at 200°C for 20 minutes, and cooled to 25°C is -0.3 to 0.5%.
[2] The laminate film according to [1], in which a dimensional change rate in a TD when the laminate film is heated from 25°C to 200°C, left to stand at 200°C for 20 minutes, and cooled to 25°C is 0 to 0.5%.
[3] The laminate film according to [1] or [2], in which a thickness of each of the first primer layer and the second primer layer is 1 $\mu$m or less.
[4] The laminate film according to any of [1] to [3], in which the first primer layer and/or the second primer layer contain silica particles.

[5] The laminate film according to any of [1] to [4], in which the first organic layer contains a polymerization product of a photocurable compound having a polymerizable functional group.

[6] The laminate film according to any of [1] to [5], in which the first inorganic thin film layer at least contains a silicon atom, an oxygen atom, and a carbon atom.

[7] The laminate film according to any of [1] to [6], in which an atomic number ratio of carbon atoms to a total number of silicon atoms, oxygen atoms, and carbon atoms contained in the first inorganic thin film layer continuously varies in 90% or more of an area of the first inorganic thin film layer in a film thickness direction of the first inorganic thin film layer.

[8] The laminate film according to any of [1] to [7], in which a carbon distribution curve has eight or more extreme values, the carbon distribution curve indicating a relationship between a distance from a surface of the first inorganic thin film layer in the film thickness direction of the first inorganic thin film layer and an atomic number ratio of carbon to the total number of silicon atoms, oxygen atoms, and carbon atoms contained in the first inorganic thin film layer at each distance.

[9] The laminate film according to any of [1] to [8], further including a protection layer on a surface of the first inorganic thin film layer on a side opposite to the first organic layer.

[10] The laminate film according to [9], in which the protection layer is a layer obtained by subjecting a coating film obtained from a coating solution containing a silicon compound to modification treatment.

[11] The laminate film according to any of [1] to [10], further including a second organic layer on a surface of the second primer layer on a side opposite to the flexible substrate.

[12] The laminate film according to [11], in which the second organic layer is an antiblocking layer.

[13] The laminate film according to [11] or [12], further including a second inorganic thin film layer on a surface of the second organic layer on a side opposite to the second primer layer.

[14] A flexible electronic device, including the laminate film according to any of [1] to [13].

EFFECT OF THE INVENTION

The laminate film of the present invention is excellent in heat resistance.

BRIEF DESCRIPTION OF THE DRAWINGS

Fig. 1 is a schematic cross-sectional view illustrating an example of a laminate film of the present invention.
Fig. 2 is a schematic cross-sectional view illustrating another example of a laminate film of the present invention.
Fig. 3 is a schematic cross-sectional view illustrating still another example of a laminate film of the present invention.
Fig. 4 is a schematic cross-sectional view illustrating another example of a laminate film of the present invention.
Fig. 5 is a schematic view illustrating an apparatus for producing a laminate film used in Examples and Comparative Examples.

MODE FOR CARRYING OUT THE INVENTION

Hereinafter, embodiments of the present invention will be described in detail. Note that the scope of the present invention is not limited to embodiments described herein, and various modifications can be made without departing from the gist of the present invention.

[Laminate film]

A laminate film of the present invention includes a second primer layer, a flexible substrate, a first primer layer, a first organic layer, and a first inorganic thin film layer in this order.

According to an embodiment of the present invention, the laminate film of the present invention includes a second inorganic thin film layer, a second organic layer, a second primer layer, a flexible substrate, a first primer layer, a first organic layer, and a first inorganic thin film layer in this order.

The laminate film of the present invention constantly satisfies the relationship $dA/dT > 0$ (referred to as the formula (1)) where T is 50 to 200°C, when the laminate film is heated while being pulled under the conditions at a tensile load of 29.4 mN and a temperature elevation rate of 20°C/min, a thermal expansion displacement in the MD is defined as A ($\mu$m) and the heating temperature is defined as T (°C). $dA/dT$ indicates the amount of change in A relative to the amount of increase in T when, in the xy coordinates, the heating temperature T is plotted on the x-axis and the thermal expansion displacement A to the heating temperature T is plotted on the y-axis. $dA/dT > 0$ indicates that the amount of change in A relative to the amount of increase in T is constantly a positive value, that is, A constantly monotonically increases in a range where T is 50 to 200°C. When T is within this range and the amount of change in A relative to the amount of increase in T includes 0 (dA/dT = 0) or a negative value (dA/dT < 0), the laminate film does not exhibit sufficient thermal expansion stability and exhibit inferior heat resistance, as a result of which cracks, wrinkles or the like are likely to occur when the laminate film is exposed to a high temperature environment. Meanwhile, when the amount of change in A is constantly positive (dA/dT > 0) in a range where T is 50 to 200°C, the laminate film can have sufficient thermal expansion stability and thus exhibit excellent heat resistance even when exposed to a high temperature (for example, 200°C). Note that dA/dT in a range where T is 50 to 200°C can be more specifically calculated by the method described in the section of [thermal linear expansion measurement of laminate film] in Examples. Incidentally, the method of making dA/dT greater than 0 is not particularly limited, and examples thereof include a method of selecting a resin with a high heat resistance as a resin used for a flexible substrate.

In the laminate film of the present invention, when the laminate film is heated from 25°C to 200°C, left to stand at 200°C for 20 minutes, and then cooled to 25°C, the dimensional change rate in the MD is -0.3 to 0.5%. In a case where the dimensional change rate in the MD is less than -0.3% or a case where the dimensional change rate exceeds 0.5%, thermal dimensional stability before and after heating is low and heat resistance is inferior, and therefore cracks, wrinkles or the like are likely to occur when the laminate film is cooled after exposure to a high temperature. In a case where the dimensional change rate in the MD is in a range of -0.3 to 0.5%, thermal dimensional stability before and after heating is high and heat resistance is excellent, and therefore cracks, wrinkles or the like are difficult to occur even when the laminate film is cooled to room temperature (for example, 25°C) after exposure to a high temperature (for example, 200°C). In addition, for the dimensional change rate in the MD, the case where the laminate film is expanded in the MD is defined as positive, and the case where the laminate film is shrunk is defined as negative. Incidentally, the method of controlling the dimensional change rate in the MD within the above-described range is not particularly limited, and examples thereof include a method of selecting a resin with high heat resistance as a resin used for a flexible substrate, and a method of adjusting the stretching ratios in the MD and TD of the flexible substrate. Note that, in the present specification, the MD of the laminate film means a flow direction in the production of the laminate film, and the TD means a direction orthogonal to the MD.

The dimensional change rate in the MD is preferably - 0.2% to 0.4%, and more preferably -0.1% to 0.3%. When the dimensional change rate in the MD falls within the above-described range, the heat resistance of the laminate film can be further enhanced.

A resin film is usually considered to shrink in the TD after heating and cooling. According to an embodiment of the present invention, when the laminate film of the present invention is heated from 25°C to 200°C, left to stand at 200°C for 20 minutes, and then cooled to 25°C, the dimensional change rate in the TD is unexpectedly 0 or more, that is, the laminate film can expand in the TD after heating and cooling. The upper limit of the dimensional change rate in the TD is preferably 0.5% or less, and more preferably 0.4% or less. The dimensional change rate in the TD may be a combination of the above-described lower limit (0 or more) and upper limit, and is preferably 0 to 0.5%, and more preferably 0 to 0.4%. When the dimensional change rate in the TD falls within the above-described range, the heat resistance of the laminate film is easily to be enhanced. Note that the dimensional change rate in the MD and the dimensional change rate in the TD can be more specifically calculated by the method described in the section of [thermal dimensional change rate measurement of laminate film] in Examples. Incidentally, the method of controlling the dimensional change rate in the TD within the above-described range is not particularly limited, and examples thereof include a method of adjusting the stretching ratios in the MD and TD of the flexible substrate and providing an organic layer or an inorganic thin film layer for fixing the state of the obtained film.

The water vapor transmission rate at 23°C 50%RH of the laminate film of the present invention is preferably 0.001 $g/m^2/day$ or less, more preferably 0.0001 $g/m^2/day$ or less, and even more preferably 0.00001 $g/m^2/day$ or less. When the water vapor transmission rate is equal to or less than the above-described upper limit, the laminate film of the present invention can have excellent gas barrier properties. The water vapor transmission rate is preferred as it is low as much, and the lower limit thereof is not particularly limited and usually 0 $g/m^2/day$ or more. Here, the water vapor transmission rate can be measured by the method described in the section of [water vapor transmission rate of laminate film] in Examples.

The method of controlling the water vapor transmission rate of the laminate film within the above-described range is not particularly limited, and examples thereof include a method of adjusting the thickness of the inorganic thin film layer and a method of adjusting the flatness of the organic layer.

In the laminate film of the present invention, when the laminate film is heated from room temperature to 150°C, the amount of dehydration in the surface of the laminate film relative to the mass of the laminate film is preferably 0.0 to 1.0%, and more preferably 0.0 to 0.5%. When the amount of dehydration in the surface falls within the above-described range, generation of outgas when exposing the laminate film to a high temperature can be suppressed. Note that, the amount of dehydration in the surface can be measured by the method described in the section of [Dehydration amount measurement of laminate film] in Examples.

In the laminate film of the present invention, the kinetic friction coefficient between one outermost surface and the other outermost surface is preferably 0.5 or less, more preferably 0.4 or less, and even more preferably 0.3 or less. In a case where the kinetic friction coefficient is equal to or less than the above-described upper limit, when the laminate film is wound in the production of the laminate film or when the cut films are stacked as necessary, damage on the laminate film is small, so that the handleability of the laminate film is easily enhanced. The lower limit of the kinetic friction coefficient is not particularly limited and is usually 0 or more. The kinetic friction coefficient can be measured in accordance with JIS K 7125.

In the laminate film of the present invention, when the laminate film cut into a square of 5 cm × 5 cm is heated from 25°C to 200°C, left to stand at 200°C for 30 minutes, and then cooled to 25°C, the warpage stability is preferably 15 mm or less, more preferably 10 mm or less, and even more preferably 5 mm or less. When the warpage stability falls within the above-described range, the laminate film has sufficient warpage stability. The lower limit of the warpage stability is 0 or more. Note that the warpage stability of the laminate film can be calculated by the method described in the section of [warpage stability of laminate film] in Examples.

The laminate film of the present invention is preferably transparent when visually observed. Specifically, the total light transmittance (Tt) of the laminate film is preferably 88.0% or more, more preferably 88.5% or more, even more preferably 89.0% or more, particularly preferably 89.5% or more, and extremely preferably 90.0% or more. When the total light transmittance of the laminate film of the present invention is equal to or more than the above-described lower limit, sufficient visibility is easily secured when the film is incorporated into flexible electronic devices such as image display devices. The upper limit of the total light transmittance of the laminate film of the present invention is not particularly limited, and needs to be 100% or less. Note that the total light transmittance can be measured by the method described in the section of [optical characteristics of laminate film] in Examples. Further, a laminate film after exposure to an environment of a temperature of 60°C and a relative humidity of 90% for 250 hours preferably still has the above-described range of total light transmittance.

The haze of the laminate film of the present invention is preferably 1.0% or less, more preferably 0.8% or less, and even more preferably 0.5% or less. When the haze of the laminate film of the present invention is equal to or less than the above-described upper limit, sufficient visibility is easily secured when the film is incorporated into flexible electronic devices such as image display devices. Note that the lower limit of the haze of the laminate film of the present invention is not particularly limited, and is usually 0% or more. A smaller haze value is preferred from the viewpoint of visibility. Note that the haze of the laminate film can be measured by the method described in the section of [Optical characteristics of laminate film] in Examples. Further, a laminate film after exposure to an environment of a temperature of 60°C and a relative humidity of 90% for 250 hours preferably still has the above-described range of haze.

The thickness of the laminate film of the present invention can be appropriately adjusted depending on applications, and is preferably 5 to 200 $\mu$m, more preferably 10 to 150 $\mu$m, and even more preferably 20 to 130 $\mu$m. Note that the thickness of the laminate film can be measured by a film thickness meter. When the thickness of the laminate film is equal to or more than the above-described lower limit, handleability as a film, surface hardness and the like are easily enhanced, which is preferable. When the thickness is equal to or less than the above-described upper limit, the bending resistance of the laminate film is easily enhanced, which is preferable.

[Flexible substrate]

A flexible substrate is a flexible substrate capable of holding an inorganic thin film layer. As the flexible substrate, a resin film containing at least one type of resin as a resin component can be used. The flexible substrate is preferably a transparent resin substrate.

Examples of the resin that can be used for the flexible substrate include polyester resins such as polyethylene naphthalate (PEN); polyolefin resins such as polyethylene (PE), polypropylene (PP), and cyclic polyolefins; polyamide resins; polycarbonate resins; polystyrene resins; polyvinyl alcohol resins; saponified products of ethylene-vinyl acetate copolymers; polyacrylonitrile resins; acetal resin; polyimide resins; polyether sulfide (PES), and polyethylene terephthalate (PET) subjected to biaxial stretching and thermal annealing treatment. As the flexible substrate, one type of the above-described resin may be used, or two or more types thereof may be used in combination. Among them, from the viewpoints that a laminate film to be obtained satisfies the formula (1) and the dimensional change rate describe above and excellent heat resistance is easily obtained, and the viewpoint that high transparency is obtained, use of a resin selected from the group consisting of polyester resins and polyolefin resins is preferable, use of a resin selected from the group consisting of PEN and cyclic polyolefins is more preferable, and use of PEN is even more preferable.

The flexible substrate may be an unstretched resin substrate or may be a stretched resin substrate obtained by stretching an unstretched resin substrate by a publicly known method such as uniaxial stretching, tenter sequential biaxial stretching, tenter simultaneous biaxial stretching, or tubular simultaneous biaxial stretching in the flow direction of the resin substrate (MD) and/or a direction orthogonal to the flow direction of the resin substrate (TD). The flexible substrate may also be a laminate in which two or more resin layers described above are laminated.

The glass transition temperature (Tg) of the flexible substrate is preferably 100°C or higher, more preferably 130°C or higher, and even more preferably 150°C or higher from the viewpoint of the heat resistance of the laminate film. Further, the upper limit of the glass transition temperature is preferably 250°C or lower. Note that the glass transition temperature (Tg) can be measured by a dynamic viscoelasticity measuring (DMA) apparatus or a differential scanning calorimeter (DSC).

The thickness of the flexible substrate may be appropriately set in consideration of, for example, stability in the production of the laminate film. The thickness is preferably 5 to 500 $\mu$m from the viewpoint of easily conveying the flexible substrate in vacuum. Further, in a case where an inorganic thin film layer is formed by the plasma CVD method, the thickness of the flexible substrate is more preferably 10 to 200 $\mu$m, and even more preferably 15 to 150 $\mu$m. Note that the thickness of the flexible substrate can be measured by a film thickness meter.

The flexible substrate may be a phase difference film such as a $\lambda/4$ phase difference film, or a $\lambda/2$ phase difference film, in which refractive indices of two orthogonal components are different from each other in a plane of the film. Examples of a material for the phase difference film include cellulose resins, polycarbonate resins, polyarylate resins, polyester resins, acrylic resins, polysulfone resins, polyether sulfone resins, cyclic olefin resins, and an orientation fixed layer of a liquid crystal compound. As a film forming method, a solvent casting method or a precisely extruding method that can minimize the residual stress of the film can be employed, and the solvent casting method is preferably employed in terms of uniformity. The stretching method is not particularly limited, and for example, roll longitudinal uniaxial stretching or tenter horizontal uniaxial stretching which brings uniform optical characteristics can be employed.

In a case where the flexible substrate is a $\lambda/4$ phase difference film, the in-plane phase difference Re (550) at a wavelength of 550 nm can be 100 to 180 nm, preferably 110 to 170 nm, and more preferably 120 to 160 nm.

In a case where the flexible substrate is a $\lambda/2$ phase difference film, the in-plane phase difference Re (550) at a wavelength of 550 nm can be 220 to 320 nm, preferably 240 to 300 nm, and more preferably 250 to 280 nm.

In a case where the flexible substrate is a phase difference film, the film may exhibit reverse wavelength dispersibility where the retardation value increases according to the wavelength of the measured light, positive wavelength characteristics where the retardation value decreases according to the wavelength of the measured light, or flat wavelength characteristics where the retardation value hardly changes by the wavelength of the measured light.

In a case where the flexible substrate is a phase difference film exhibiting reverse wavelength dispersibility, when the phase difference at a wavelength $\lambda$ of the flexible substrate is denoted as Re ($\lambda$), the flexible substrate can satisfy Re (450)/Re (550) < 1 and Re (650)/Re (550) > 1.

The flexible substrate is preferably colorless and transparent from the viewpoint of capable of transmitting or absorbing light. More specifically, the total light transmittance is preferably 80% or more, and more preferably 85% or more. In addition, the haze value (haze) is preferably 5% or less, more preferably 3% or less, and even more preferably 1% or less.

From the viewpoint of capable of being used as a substrate for organic devices or energy devices, the flexible substrate is preferably an insulating substrate, and the electric resistivity is preferably $10^6$ $\Omega$cm or more.

The surface of the flexible substrate may be subjected to a surface activation treatment for cleaning the surface thereof from the viewpoint of adhesion to an organic layer or the like. Examples of such a surface activation treatment include corona treatment, plasma treatment, and flame treatment.

The flexible substrate may or may not be subjected to annealing treatment, but is preferably subjected to annealing treatment from the viewpoint of easily enhancing the thermal dimensional stability and heat resistance of the laminate film. Examples of the annealing treatment include heating the flexible substrate at a temperature equal to or higher than the upper limit temperature for use (for example, 200°C) while biaxially stretching the substrate; and biaxially stretching the flexible substrate and then passing the substrate through a heating furnace set at a temperature equal to or higher than the upper limit temperature for use (for example, 200°C) in the offline. Note that the flexible substrate may be subjected to annealing treatment, or a flexible substrate in which a second primer layer and a first primer layer are laminated on both surfaces of the flexible substrate, may be subjected to annealing treatment.

[Primer layer]

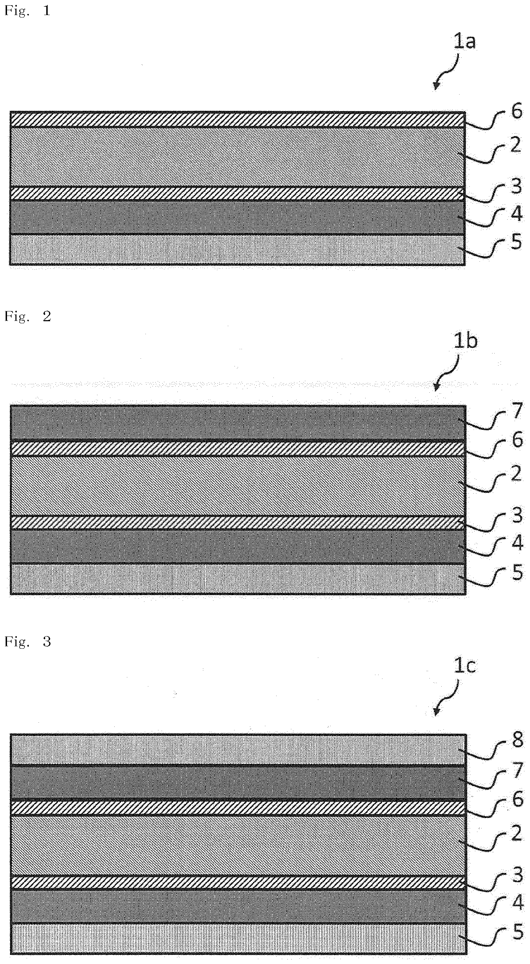

The laminate film of the present invention includes a first primer layer between a flexible substrate and a first organic layer, and a second primer layer on a surface of the flexible substrate on a side opposite to the first primer layer. By providing the first primer layer, adhesion between the flexible substrate and the first organic layer can be enhanced, and the heat resistance of the laminate film can be enhanced. In a case where no layer exists on a surface of the second primer layer on a side opposite to the flexible substrate, that is, in a case where the second primer layer is the outermost layer (for example, the configuration shown in Fig. 1), the second primer layer functions as a protection layer of the laminate film and also functions as enhancing slipping in the production and preventing blocking. Further, in a case where the laminate film further includes a second organic layer on a surface of the second primer layer on a side opposite to the flexible substrate (for example, the configurations shown in Figs. 2 and 3), by providing the second primer layer, adhesion between the flexible substrate and the second organic layer can be enhanced, so that the heat resistance of the laminate film can be further enhanced. Incidentally, the laminate film of the present invention may include another primer layer laminated on another portion as long as the laminate film includes at least one first primer layer and one second primer layer existing in the order described above. Note that, in the present specification, the first primer layer and the second primer layer are collectively referred to as "primer layer" in some cases.

The first primer layer and the second primer layer each have a softening temperature of 130°C or higher. When the primer layer has such a softening temperature, the heat resistance of the laminate film can be enhanced, and the flexible substrate and the organic layer can be sufficiently adhered even in a high temperature environment. The softening temperature of each of the first primer layer and the second primer layer is preferably 130°C or higher, more preferably 160°C or higher, or even more preferably 180°C or higher. When the softening temperature of the primer layer is equal to or higher than the above-described lower limit, heat resistance can be further enhanced. Also, the upper limit of the softening temperature of the primer layer is usually 250°C or lower.

The first primer layer and the second primer layer each preferably contain at least one selected from urethane resin, acrylic resin, polyester resin, epoxy resin, melamine resin, and amino resin. Among them, from the viewpoint of the heat resistance of the laminate film, more preferably, either of the first primer layer or the second primer layer contains polyester resin as a main component, and even more preferably, both of the first primer layer and the second primer layer contain polyester resin as a main component.

The first primer layer and the second primer layer may each contain an additive in addition to the above-described resin. As the additive, publicly known additives can be used for formation of the primer layer. Examples of the additive include inorganic particles such as silica particles, alumina particles, calcium carbonate particles, magnesium carbonate particles, barium sulfate particles, aluminum hydroxide particles, titanium dioxide particles, zirconium oxide particles, clay, and talc. Among them, silica particles are preferable from the viewpoint of the heat resistance of the laminate film.

The average primary particle size of the silica particle that can be contained in the first primer layer and the second primer layer is preferably 5 nm or more, more preferably 10 nm or more, even more preferably 15 nm or more, and particularly preferably 20 nm or more; preferably 100 nm or less, more preferably 80 nm or less, even more preferably 60 nm or less, and particularly preferably 40 nm or less. When the average primary particle size of the silica particle falls within the above-described range, aggregation of the silica particle is suppressed, and the transparency and heat resistance of the laminate film can be enhanced. Further, in a case where the second primer layer is the outermost layer, when the average primary particle size of the silica particle falls within the above-described range, slipping of the laminate film in the production can be further enhanced, and blocking can be effectively prevented. Note that the average primary particle size of the silica particle can be measured by a BET method or TEM observation of the cross-sections of the particles.

The content of silica particles is preferably 1 to 50 mass%, more preferably 1.5 to 40 mass%, and even more preferably 2 to 30 mass% relative to the mass of each primer layer. When the content of silica particles is equal to or more than the above-described lower limit, the heat resistance of the laminate film is easily enhanced. When the content of silica particles is equal to or less than the above-described upper limit, optical characteristics such as low haze and high total light transmittance are easily to be enhanced.

The thickness of each of the first primer layer and the second primer layer is preferably 1 $\mu$m or less, more preferably 500 nm or less, and even more preferably 200 nm or less; preferably 10 nm or more, more preferably 30 nm or more, and even more preferably 50 nm or more. When the thickness of the primer layer falls within the above-described range, adhesion between the primer layer and the organic layer, and the heat resistance of the laminate film are easily enhanced. Note that the thickness of the primer layer can be measured by a film thickness meter. The thicknesses of the first primer layer and the second primer layer may be the same or different. From the viewpoint of easily enhancing the heat resistance of the laminate film, the thicknesses of the first primer layer and the second primer layer are preferably the same. In a case where the laminate film of the present invention includes three or more primer layers, each primer layer preferably has the above-described thickness.

The primer layer can be obtained by applying a resin composition containing a resin and a solvent, and as necessary, an additive onto a flexible substrate and drying the coating film to form a film. The order of forming the first primer layer and the second primer layer is not particularly limited.

The solvent is not particularly as long as it can dissolve the resin, and examples thereof include alcohol solvents such as methanol, ethanol, 2-propanol, 1-butanol, and 2-butanol; ether solvents such as diethyl ether, diisopropyl ether, tetrahydrofuran, 1,4-dioxane, and propylene glycol monomethyl ether; ketone solvents such as acetone, 2-butanone, and methyl isobutyl ketone; aprotic polar solvents such as N,N-dimethylformamide, N,N-dimethylacetamide, N-methyl-2-pyrrolidone, N-ethyl-2-pyrrolidone, and dimethylsulfoxide; ester solvents such as methyl acetate, ethyl acetate, and n-butyl acetate; nitrile solvents such as acetonitrile, and benzonitrile; hydrocarbon solvents such as n-pentane, n-hexane, n-heptane, octane, cyclohexane, and methylcyclohexane; aromatic hydrocarbon solvents such as benzene, toluene, xylene, and mesitylene; halogenated hydrocarbon solvents such as methylene chloride, chloroform, carbon tetrachloride, 1,2-dichloroethane, monochlorobenzene, and dichlorobenzene. The solvent can be used singly or two or more types thereof can be used in combination.

Examples of the method of applying a primer layer to a flexible substrate include various types of application methods conventionally used such as spray coating, spin coating, bar coating, curtain coating, an immersion method, an air knife method, slide coating, hopper coating, reverse roller coating, gravure coating, and extrusion coating.

The method of drying a coating film include natural drying, ventilation drying, heat drying, and reduced-pressure drying, and heat drying is preferably employed. The drying temperature is, while depending on the type of resin or solvent, usually approximately 50 to 350°C, and the drying time is usually approximately 30 to 300 seconds.

As described above, the first primer layer and the second primer layer may each be formed on both surfaces of the flexible substrate, but a commercially available film including primer layers on both surfaces of the flexible substrate, such as "TEONEX (registered trademark)" available from Teijin Film Solutions can also be used.

The first primer layer and the second primer layer may each be a monolayer or a multilayer of two or more layers. Further, the first primer layer and the second primer layer may be layers formed of the same composition or layers formed of different compositions. However, from the viewpoint of easily enhancing the heat resistance of the laminate film, the first primer layer and the second primer layer are preferably layers formed of the same composition. Additionally, in a case where the laminate film of the present invention includes a primer layer other than the first primer layer and the second primer layer, a plurality of primer layers may also be layers formed of the same composition or layers formed of different compositions.

[Organic layer]

The laminate film of the present invention includes a first organic layer on a surface of the first primer layer on a side opposite to the flexible substrate. By providing the first organic layer, the heat resistance of the laminate film can be enhanced, so that defects such as cracks, wrinkles, and warpage are less likely to occur even when exposing the laminate film to a high temperature environment. The laminate film of the present invention may further include another organic layer laminated on another portion as long as the laminate film includes at least one first organic layer existing in the order described above. According to an embodiment of the present invention, the laminate film further includes a second organic layer on a surface of the second primer layer on a side opposite to the flexible substrate. By providing the second organic layer, the heat resistance of the laminate film can be further enhanced. Specifically, by providing the second organic layer with the laminate film, precipitation of the resin component or the like of the flexible substrate and deformation of the flexible substrate is suppressed, so that increase in haze is suppressed even when exposing the laminate film to a high temperature environment.

Note that, in the present specification, the first organic layer and the second organic layer are collectively referred to as "organic layer" in some cases.

The first organic layer and the second organic layer may each be a layer having a function as a planarization layer, a layer having a function as an antiblocking layer, or a layer having both functions. Further, preferably, the second organic layer is an antiblocking layer from the viewpoint of securing slipping during film conveyance. More preferably, the first organic layer is a planarization layer and the second organic layer is an antiblocking layer from the viewpoint of both stabilizing barrier properties by the homogenization of the first inorganic thin film layer and securing slipping during conveyance of the film. The first organic layer and the second organic layer may each be a monolayer or a multilayer of two or more layers. Further, the first organic layer and the second organic layer may be layers formed of the same composition or layers formed of different compositions. However, from the viewpoint of easily enhancing the heat resistance of the laminate film, the first organic layer and the second organic layer are preferably layers formed of the same composition. In a case where the laminate film of the present invention includes an organic layer other than the first organic layer and the second organic layer, a plurality of organic layers may also be layers formed of the same composition or layers formed of different compositions.

The thickness of each of the first organic layer and the second organic layer may be appropriately adjusted depending on applications, and is preferably 0.1 to 5 $\mu$m, more preferably 0.5 to 3 $\mu$m, and even more preferably 0.7 to 3 $\mu$m. Note that the thickness of the organic layer can be measured by a film thickness meter. When the thickness is equal to or more than the above-described lower limit, the surface hardness of the laminate film is easily enhanced. When the thickness is equal to or less than the above-described upper limit, flexibility is easily enhanced. The thicknesses of the first organic layer and the second organic layer may be the same or different. In a case where the laminate film of the present invention includes three or more organic layers, each organic layer preferably has the above-described thickness.

The organic layer can be formed by, for example, applying a composition containing a photocurable compound having a polymerizable functional group onto a primer layer and curing the composition. As the photocurable compound contained in a composition for forming the organic layer, ultraviolet-ray curable or electron beam curable compounds are exemplified. Examples of such a compound include compounds having, in the molecule, one or more polymerizable functional groups such as a (meth)acryloyl group, a vinyl group, a styryl group, and an allyl group. The composition for forming the organic layer (may be referred to as "organic layer forming composition") may contain one type of photocurable compound or two or more types of photocurable compounds. By curing the photocurable compound having a polymerizable functional group contained in the organic layer forming composition, the photocurable compound is polymerized, so that an organic layer containing a polymerization product of the photocurable compound is formed.

The reaction rate of the polymerizable functional group of the photocurable compound having the polymerizable functional group in the organic layer is preferably 70% or more, more preferably 75% or more, and even more preferably 80% or more from the viewpoint of easily enhancing the quality of appearance. The upper limit of the reaction rate is not particularly limited, and is preferably 95% or less, and more preferably 90% or less from the viewpoint of easily enhancing the quality of appearance. When the reaction rate is equal to or more than the above-described lower limit, the laminate film is likely to be colorless and transparent. When the reaction rate is equal to or less than the above-described upper limit, bending resistance is easily enhanced. The reaction rate increases with progression of the polymerization reaction of the photocurable compound having a polymerizable functional group. Thus, for example, in a case where the photocurable compound is an ultraviolet-ray curable compound, the reaction rate can be increased by increasing the intensity of the ultraviolet ray to be irradiated or increasing irradiation time. By adjusting the curing conditions as described above, the reaction rate can be controlled within the above-described range.

The reaction rate can be measured by preparing a coating film before curing obtained by applying an organic layer forming composition onto a substrate and as necessary drying the composition, and a coating film obtained by curing the above-described coating film; measuring the infrared absorption spectra for the surface of these coating films by using a total reflection-type FT-IR; and determining the reaction rate based on the amount of change in the intensity of the peak derived from the polymerizable functional group. For example, in a case where the polymerizable functional group is a (meth)acryloyl group, the C=C double bond moiety in the (meth)acryloyl group is a group related to polymerization. The intensity of the peak derived from the C=C double bond decreases with increase in the reaction rate of polymerization. On the other hand, the C=O double bond moiety in the (meth)acryloyl group is not related to polymerization, and the intensity of the peak derived from the C=O double bond does not change before and after polymerization. Thus, the reaction rate can be calculated by comparing the ratio ($I_{CC1}/I_{CO1}$) of the intensity of the peak derived from the C=C double bond ($I_{CC1}$) to the intensity of the peak derived from the C=O double bond ($I_{CO1}$) in the (meth)acryloyl group in the infrared absorption spectrum measured for the coating film before curing with the ratio ($I_{CC2}/I_{CO2}$) of the intensity of the peak derived from the C=C double bond ($I_{CC2}$) to the intensity of the peak derived from the C=O double bond ($I_{CO2}$) in the (meth)acryloyl group in the infrared absorption spectrum measured for the coating film after curing. In this case, the reaction rate is calculated from the formula (3):

$$\text{Reaction rate } [\%] = [1 - (I_{CC2}/I_{CO2})/(I_{CC1}/I_{CO1})] \times 100$$

(3) Note that the infrared absorption peak derived from the C=C double bond is usually observed in a range of 1,350 to 1,450 $cm^{-1}$, for example, around 1,400 $cm^{-1}$, and the infrared absorption peak derived from the C=O double bond is usually observed in a range of 1,700 to 1,800$cm^{-1}$, for example, around 1,700 $cm^{-1}$.

When, in the infrared absorption spectrum of the organic layer, the intensity of the infrared absorption peak in a range of 1,000 to 1,100 $cm^{-1}$ is defined as $I_a$, and the intensity of the infrared absorption peak in a range of 1,700 to 1,800 $cm^{-1}$ is defined as $I_b$, $I_a$ and $I_b$ preferably satisfy the formula (4):

$$0.05 \leq I_b/I_a \leq 1.0 \quad (4).$$

Here, it is conceived that the infrared absorption peak in a range of 1,000 to 1,100 $cm^{-1}$ is an infrared absorption peak derived from an Si-O-Si bond derived from siloxane present in a compound and polymerization product contained in the organic layer (for example, a photocurable compound having a polymerizable functional group and/or a polymerization product thereof), and the infrared absorption peak in a range of 1,700 to 1,800 $cm^{-1}$ is an infrared absorption peak derived from a C=O double bond present in a compound and polymerization product contained in the organic layer (for example, a photocurable compound having a polymerizable functional group and/or a polymerization product thereof). Thus, the ratio of intensities of these peaks ($I_b/I_a$) is considered to represent a relative proportion of the Si-O-Si bond derived from siloxane to the C=O double bond in the organic layer. When the ratio of intensities of the peaks ($I_b/I_a$) falls within the above-described predetermined range, uniformity of the organic layer is easily enhanced, and adhesion between layers, particularly, adhesion in a high humidity environment is easily enhanced. The ratio of intensities of the peaks ($I_b/I_a$) is preferably 0.05 or more, more preferably 0.10 or more, and even more preferably 0.20 or more. When the ratio of the peak intensity is equal to or more than the above-described lower limit, uniformity of the organic layer is easily enhanced. Although the present invention is not limited to the mechanism descried later, the reason for this is considered that, when the amount of the Si-O-Si bond derived from siloxane existing in a compound and polymerization product contained in the organic layer is excessively large, aggregates are generated in the organic layer, as a result of which the layer becomes brittle in some cases, and the generation of such aggregates tends to be reduced accordingly. The ratio of the peak intensity ($I_b/I_a$) is preferably 1.0 or less, more preferably 0.8 or less, and even more preferably 0.5 or less. When the ratio of the peak intensity is equal to or less than the above-described upper limit, adhesion of the organic layer is easily enhanced. Although the present invention is not limited to the mechanism descried later, the reason for this is considered that, when a predetermined amount or more of the Si-O-Si bond derived from siloxane exists in a compound and polymerization product contained in the organic layer, the hardness of the organic layer is appropriately reduced. The infrared absorption spectrum of the organic layer can be measured by a Fourier transformation type infrared spectrophotometer (FT/IR-460 Plus, available from JASCO Corporation) equipped with an ATR attachment (PIKE MIRacle).

The photocurable compound contained in the organic layer forming composition is a compound that stats its polymerization by an ultraviolet ray or the like and is formed into resin which is a polymerization product through progression of curing. From the viewpoint of curing efficiency, the photocurable compound is preferably a compound having a (meth)acryloyl group. The compound having a (meth)acryloyl group may be a monofunctional monomer or oligomer, or may be a polyfunctional monomer or oligomer. Note that, in the present specification, "(meth)acryloyl" represents acryloyl and/or methacryloyl, and "(meth)acryl" represents acryl and/or methacryl.

As the compound having a (meth)acryloyl group, (meth)acrylic compounds are exemplified. Specific examples thereof include alkyl(meth)acrylates, urethane(meth)acrylates, ester(meth)acrylates, epoxy(meth)acrylates, and polymers and copolymers thereof. Specific examples thereof include methyl (meth)acrylate, butyl (meth)acrylate, methoxyethyl (meth)acrylate, butoxyethyl (meth)acrylate, phenyl (meth)acrylate, ethylene glycol di(meth)acrylate, propylene glycol di(meth)acrylate, neopentyl glycol di(meth)acrylate, dipropylene glycol di(meth)acrylate, ethylene glycol di(meth)acrylate, propylene glycol di(meth)acrylate, pentaerythritol tri(meth)acrylate, and polymers and copolymers thereof.

The photocurable compound contained in the organic layer forming composition preferably contains, in place of or in addition to the compound having a (meth)acryloyl group, for example, metetramethoxysilane, tetraethoxysilane, methyltrimethoxysilane, methyltriethoxysilane, ethyltrimethoxysilane, ethyltriethoxysilane, isopropyltrimethoxysilane, isobutyltrimethoxysilane, cyclohexyltrimethoxysilane, n-hexyl trimethoxysilane, n-octyl triethoxysilane, n-decyl trimethoxysilane, phenyltrimethoxysilane, dimethyldimethoxysilane, diisopropyldimethoxysilane, trimethylethoxysilane, and triphenylethoxysilane. Alkoxysilanes other than these substances may also be used.

Examples of a photocurable compound other than the photocurable compound having a polymerizable functional group described above include monomers or oligomers that are polymerized to be resins such as polyester resins, isocyanate resins, ethylene vinyl alcohol resins, vinyl-modified resins, epoxy resins, phenol resins, urea melamine resins, styrene resins, and alkyl titanates.

The organic layer forming composition may contain inorganic particles described in the section of [primer layer], preferably silica particles. The average primary particle size of the silica particle contained in the organic layer forming composition is preferably 5 to 100 nm, and more preferably 5 to 75 nm. When the organic layer forming composition contains inorganic particles, the heat resistance of the laminate film is easily enhanced.

The content of inorganic particles, preferably, silica particles is preferably 20 to 90%, and more preferably 40 to 85% relative to the mass of the solid content of the organic layer forming composition. When the content of inorganic particles falls within the above-described range, the heat resistance of the laminate film is easily further enhanced. Note that the solid content of the organic layer forming composition refers to components contained in the organic layer forming composition, excluding volatile components such as a solvent.

From the viewpoint of the curability of the organic layer, the organic layer forming composition may contain a photopolymerization initiator. From the viewpoint of enhancing the curability of the organic layer, the content of the photopolymerization initiator is preferably 2 to 15%, and more preferably 3 to 11% relative to the mass of the solid content of the organic layer forming composition.

The organic layer forming composition may contain a solvent from the viewpoint of coatability. As the solvent, those capable of dissolving the photocurable compound having a polymerizable functional group can be appropriately selected according to the type of photocurable compound, and solvents described in, for example, the section of [primer layer] are exemplified. The solvent may be used singly or two or more types thereof may be used in combination.

In addition to the photocurable compound having a polymerizable functional group, the inorganic particles, the photopolymerization initiator, and the solvent, the organic layer forming composition may contain, as necessary, additives such as a thermal polymerization initiator, an antioxidant, an ultraviolet absorber, a plasticizer, a leveling agent, and a curl reducing agent.

The organic layer can be formed by, for example, applying an organic layer forming composition containing a photocurable compound (photocurable compound) onto a primer layer, as necessary, drying the composition, and irradiating with ultraviolet rays or electron beams to cure the photocurable compound.

Examples of the coating method include methods similar to the method for applying the primer layer to the flexible substrate.

In a case where the organic layer has a function as a planarization layer, the organic layer may contain (meth)acrylate resins, polyester resins, isocyanate resins, ethylene vinyl alcohol resins, vinyl-modified resins, epoxy resins, phenol resins, urea melamine resins, styrene resins, and alkyl titanates. The organic layer may contain one type of resin or contain two or more types of these resins in combination.

In a case where the organic layer has a function as a planarization layer, in the planarization layer, when the temperature change of the elastic modulus of the surface of the planarization layer is evaluated by a rigid body pendulum-type physical property tester (for example, RPT-3000W, available from A&D Company, Limited), a temperature at which the elastic modulus of the surface of the planarization layer decreases by 50% or more is preferably 150°C or higher.

In a case where the organic layer has a function as a planarization layer, the surface roughness measured by observing the planarization layer by a white light interferometric microscope is preferably 3 nm or less, more preferably 2 nm or less, and even more preferably 1 nm or less. When the surface roughness of the planarization layer is equal to or less than the above-descried upper limit, effects are provided such as decrease in defects of the inorganic thin film layer, and enhancement of gas barrier properties. The surface roughness is measured by observing the planarization layer by a white light interferometric microscope based on fringes formed according to the unevenness on the surface of the sample.

In a case where the organic layer has a function as an antiblocking layer, the organic layer preferably contains, particularly, the inorganic particles described above.

[Inorganic thin film layer]

The laminate film of the present invention includes a first inorganic thin film layer on a surface of the first organic layer on a side opposite to the first primer layer. By providing the first inorganic thin film layer, the laminate film can have excellent gas barrier properties. Note that the laminate film of the present invention may include another inorganic thin film layer laminated on another portion as long as the laminate film includes at least one first inorganic layer existing in the order described above. According to an embodiment of the present invention, the laminate film further includes a second inorganic thin film layer on a surface of the second organic layer on a side opposite to the second primer layer. By providing the second inorganic thin film layer, the gas barrier properties of the laminate film can be enhanced. Note that, in the present specification, the first inorganic thin film layer and the second inorganic thin film layer are collectively referred to as "inorganic thin film layer" in some cases.

The first inorganic thin film layer and the second inorganic thin film layer may each be a layer having a function as a gas barrier layer, a layer having a function as a warpage control layer, or a layer having both functions. In a case where the first inorganic thin film layer and the second inorganic thin film layer are at least a gas barrier layer, these layers are not particularly limited as long as they are inorganic material layers having gas barrier properties, and publicly known inorganic material layers having gas barrier properties can be appropriately utilized. Examples of the inorganic material include metal oxides, metal nitrides, metal oxynitrides, and metal oxycarbides, and mixtures containing at least two of these. The inorganic thin film layer may be a monolayer film or a multilayer film in which two or more layers including at least the above-described thin film layer are laminated.

The thickness of each of the first inorganic thin film layer and the second inorganic thin film layer may be appropriately adjusted depending on applications, and is preferably 0.1 to 2 $\mu$m, more preferably 0.2 to 1.5 $\mu$m, and even more preferably 0.3 to 1 $\mu$m. Note that the thickness of the inorganic thin film layer can be measured by a film thickness meter. When the thickness is equal to or more than the above-described lower limit, gas barrier properties are easily enhanced. When the thickness is equal to or less than the above-described upper limit, flexibility is easily enhanced. The thicknesses of the first inorganic thin film layer and the second inorganic thin film layer may be the same or different. In a case where the laminate film of the present invention includes three or more inorganic thin film layers, each inorganic thin film layer preferably has the above-described thickness.

The first inorganic thin film layer and the second inorganic thin film layer may each be a monolayer or a multilayer of two or more layers. Further, the first inorganic thin film layer and the second inorganic thin film layer may be layers formed of the same composition or layers formed of different compositions. However, from the viewpoint of easily enhancing the heat resistance of the laminate film, the first inorganic thin film layer and the second inorganic thin film layer are preferably layers formed of the same composition. In addition, in a case where the laminate film of the present invention includes an inorganic thin film layer other than the first inorganic thin film layer and the second inorganic thin film layer, a plurality of inorganic thin film layers may also be layers formed of the same composition or layers formed of different compositions.

The inorganic thin film layer preferably contains at least a silicon atom (Si), an oxygen atom (0), and a carbon atom (C) from the viewpoint of easily exerting a higher level of gas barrier properties (particularly, a property of preventing water vapor transmission) as well as bending resistance, ease in production, and low production cost.

In this case, the inorganic thin film layer may contain a compound represented by the general formula $SiO_{\alpha}C_{\beta}$ as a main component. In the formula, $\alpha$ and $\beta$ each independently represent a positive number of less than 2. Here, "containing as a main component" refers to the content of the component being 50 mass% or more, preferably 70 mass% or more, and more preferably 90 mass% or more relative to the mass of all the components of the material. The inorganic thin film layer may contain one type of compound represented by the general formula $SiO_{\alpha}C_{\beta}$ and may contain two or more types of compounds represented by the general formula $SiO_{\alpha}C_{\beta}$. $\alpha$ and/or $\beta$ in the general formula may be constant or variable in the film thickness direction of the inorganic thin film layer.

The inorganic thin film layer may contain an element other than a silicon atom, an oxygen atom, and a carbon atom, for example, at least one atom of a hydrogen atom, a nitrogen atom, a boron atom, an aluminum atom, a phosphorus atom, a sulfur atom, a fluorine atom, and a chlorine atom.

In the inorganic thin film layer, when the average atomic number ratio of a carbon atom (C) to a silicon atom (Si) in the thin film layer is represented by C/Si, the range of C/Si preferably satisfies the formula (5) from the viewpoint of increasing denseness and decreasing defects such as small gaps and cracks.

$$0.02 < C/Si < 0.50 \quad (5)$$

From the same point of view, C/Si is more preferably in a range of 0.03 < C/Si < 0.45, even more preferably in a range of 0.04 < C/Si < 0.40, and particularly preferably in a range of 0.05 < C/Si < 0.35.

Further, in the inorganic thin film layer, when the average atomic number ratio of an oxygen atom (0) to a silicon atom (Si) in the thin film layer is represented by O/Si, the ratio is preferably in a range of 1.50 < O/Si < 1.98, more preferably in a range of 1.55 < O/Si < 1.97, even more preferably in a range of 1.60 < O/Si < 1.96, and particularly preferably in a range of 1.65 < O/Si < 1.95 from the viewpoint of increasing denseness and decreasing defects such as small gaps and cracks

Note that the average atomic number ratios C/Si and O/Si can be calculated after XPS depth profile measurement is performed under the following conditions and the average atom concentration of each atom in the thickness direction is determined from the obtained distribution curve of a silicon atom, an oxygen atom, and a carbon atom.

<XPS depth profile measurement>

Etching ion species: Argon ($Ar^+$)
Etching rate (conversion value in terms of $SiO_2$ thermal oxide film): 0.027 nm/sec
Sputtering time: 0.5 minutes
X-ray photoelectron spectroscopic apparatus: (Model name: "Quantera SXM", available from ULVAC-PHI, Inc.)
X-rays to be irradiated: single crystal spectrum $AlK\alpha$ (1486.6 eV)
X-ray spot and size: 100 $\mu$m
Detector: Pass Energy 69 eV, Step size 0.125 eV
Electrification correction: neutralization electron gun (1 eV), slow Ar ion gun (10V)

When the surface of the inorganic thin film layer is subjected to infrared spectrometry (ATR method), the intensity ratio ($I_2/I_1$) of the intensity (12) of a peak at 1,240 to 1,290 $cm^{-1}$ to the intensity ($I_1$) of a peak at 950 to 1,050 $cm^{-1}$ preferably satisfies the formula (6).

$$0.01 \leq I_2/I_1 < 0.05 \quad (6)$$

The peak intensity ratio $I_2/I_1$ calculated from infrared spectrometry (ATR method) is considered to represent the relative ratio of an $Si\text{-}CH_3$ bond to an $Si\text{-}O\text{-}Si$ bond in the inorganic thin film layer. The inorganic thin film layer satisfying the relationship represented by the formula (6) is considered to exhibit improved gas barrier properties and impact resistance because it has high denseness and tends to exhibit reduced defects such as small gaps and cracks. The peak intensity ratio $I_2/I_1$ is more preferably in a range of $0.02 \leq I_2/I_1 < 0.04$ from the viewpoint of easily maintaining high denseness of the inorganic thin film layer.

When the inorganic thin film layer satisfies the above-described range of the peak intensity ratio $I_2/I_1$, the laminate film of the present invention easily exhibits appropriate slidability and reduced blocking. An excessively large

peak intensity ratio $I_2/I_1$ indicates an excessively large amount of the Si-C bond. In this case, flexibility and slipping tend to be poor. Meanwhile, an excessively small peak intensity ratio $I_2/I_1$ indicates an excessively small amount of the Si-C bond, and flexibility tends to decrease.

Infrared spectrometry of the surface of the inorganic thin film layer can be performed by a Fourier transformation type infrared spectrophotometer (FT/IR-460 Plus, available from JASCO Corporation) equipped with an ATR attachment (PIKE MIRacle) using a germanium crystal as the prism.

When the surface of the inorganic thin film layer is subjected to infrared spectrometry (ATR method), the intensity ratio ($I_3/I_1$) of the intensity ($I_3$) of a peak at 770 to 830cm$^{-1}$ to the intensity ($I_1$) of a peak at 950 to 1,050 cm$^{-1}$ preferably satisfies the formula (7).

$$0.25 \leq I_3/I_1 \leq 0.50 \quad (7)$$

The peak intensity ratio $I_3/I_1$ calculated from infrared spectrometry (ATR method) is considered to represent the relative ratio of an Si-C bond, an Si-O bond or the like to an Si-O-Si bond in the inorganic thin film layer. The inorganic thin film layer satisfying the relationship represented by the formula (7) is considered to easily enhance bending resistance and impact resistance because carbon is introduced while maintaining high denseness. The peak intensity ratio $I_3/I_1$ is preferably $0.25 \leq I_3/I_1 \leq 0.50$, and more preferably $0.30 \leq I_3/I_1 \leq 0.45$ from the viewpoint of maintaining the balance between the denseness and bending resistance of the inorganic thin film layer.

When the surface of the thin film layer is subjected to infrared spectrometry (ATR method), the intensity ratio of the intensity ($I_4$) of a peak at 870 to 910 cm$^{-1}$ to the intensity ($I_3$) of a peak at 770 to 830 cm$^{-1}$ preferably satisfies the formula (8).

$$0.70 \leq I_4/I_3 < 1.00 \quad (8)$$

The peak intensity ratio $I_4/I_3$ calculated from infrared spectrometry (ATR method) is considered to represent the ratio of peaks related to an Si-C bond in the inorganic thin film layer. The inorganic thin film layer satisfying the relationship represented by the formula (8) is considered to easily enhance bending resistance and impact resistance because carbon is introduced while maintaining high denseness. The range of the peak intensity ratio $I_4/I_3$ is preferably in a range of $0.70 \leq I_4/I_3 < 1.00$, and more preferably in a range of $0.80 \leq I_4/I_3 < 0.95$ from the viewpoint of maintaining the balance between the denseness and bending resistance of the inorganic thin film layer.

The thickness of the inorganic thin film layer is preferably 5 to 3,000 nm from the viewpoint of being difficult to be broken when the inorganic thin film layer is bent. When the thin film layer is formed by a plasma CVD method using a glow discharge plasma as will be described later, the thickness of the thin film layer is more preferably 10 to 2,000 nm, and even more preferably 100 to 1,000 nm because the thin film layer is formed while discharging through the substrate.

The inorganic thin film layer may preferably have an average density as high as 1.8 g/cm$^3$ or more. The "average density" of the inorganic thin film layer herein can be determined by calculating the weight of the thin film layer in the measured range from the number of silicon atoms, carbon atoms, and oxygen atoms determined by rutherford backscattering spectrometry (RBS) and from the number of hydrogen atoms determined by hydrogen forward scattering spectrometry (HFS) and dividing the weight by the volume (product of the area irradiated with ion beams and the film thickness) of the thin film layer in the measured range. When the average density of the inorganic thin film layer is equal to or more than the above-described lower limit, the laminate film has a configuration with high denseness and reduced defects such as small gaps and cracks, which is preferable. In a preferred embodiment of the present invention in which the inorganic thin film layer includes a silicon atom, an oxygen atom, a carbon atom, and a hydrogen atom, the average density of the inorganic thin film layer is preferably less than 2.22 g/cm$^3$.

In a preferred embodiment of the present invention in which the inorganic thin film layer contains at least a silicon atom (Si), an oxygen atom (O), and a carbon atom (C), a curve is referred to as a silicon distribution curve which shows a relationship between a distance from the surface of the inorganic thin film layer in the film thickness direction of the inorganic thin film layer and an atomic ratio of a silicon atom at each distance. Here, the surface of the inorganic thin film layer indicates a plane to be the surface of the laminate film of the present invention. Similarly, a curve is referred to as an oxygen distribution curve which shows a relationship between a distance from the surface of the inorganic thin film layer in the film thickness direction and an atomic ratio of an oxygen atom at each distance. Further, a curve is referred to as a carbon distribution curve which shows a relationship between a distance from the surface of the inorganic thin film layer in the film thickness direction and an atomic ratio of a carbon atom at each distance. The atomic ratios of a silicon atom, oxygen atom, and carbon atom mean the ratio of the number of silicon atoms, the ratio of the number of oxygen atoms, and the ratio of the number of carbon atoms, relative to the total number of silicon atoms, oxygen atoms, and carbon atoms contained in the inorganic thin film layer respectively.

From the viewpoint of easily suppressing decrease in gas barrier properties due to bending, the atomic number ratio of carbon atoms to the total number of silicon atoms, oxygen atoms, and carbon atoms contained in the inorganic thin film layer preferably varies continuously in 90% or more of an area of the inorganic thin film layer in the film thickness direction. Here, "the atomic number ratio of carbon atoms continuously varying in the film thickness direction of the inorganic thin film layer" represents, for example, that the carbon distribution curve does not include a part where the atomic ratio of carbon discontinuously varies.

It is preferred that the carbon distribution curve of the inorganic thin film layer have eight or more extreme values from the viewpoint of flexibility and gas barrier properties of the laminate film.

The silicon distribution curve, the oxygen distribution curve, and the carbon distribution curve of the inorganic thin film layer preferably satisfy the following conditions (i) and (ii) from the viewpoint of flexibility and gas barrier properties of the laminate film.

(i) the atomic number ratio of silicon, the atomic number ratio of oxygen, and the atomic number ratio of carbon satisfy the condition represented by the following formula (9) in 90% or more of an area of the thin film layer in the film thickness direction: and

$$\text{(atomic number ratio of oxygen)} > \text{(atomic number ratio of silicon)} > \text{(atomic number ratio of carbon)} \quad (9)$$

(ii) the carbon distribution curve preferably has at least one extreme value, more preferably eight or more extreme values.

The carbon distribution curve of the inorganic thin film layer is preferably substantially continuous. The carbon distribution curve being substantially continuous means that the carbon distribution curve does not include a part where the atomic ratio of carbon discontinuously varies. Specifically, when a distance from the surface of the thin film layer in the film thickness direction is defined as x [nm] and the atomic ratio of carbon is defined as C, it is preferable to satisfy the formula (10).

$$|dC/dx| \leq 0.01 \quad (10)$$

Further, the carbon distribution curve of the inorganic thin film layer preferably has at least one extreme value, and more preferably has eight or more extreme values. The extreme value herein means the maximum value or the minimum value of the atomic ratio of each element to the distance from the surface of the inorganic thin film layer in the film thickness direction. The extreme value is a value of atomic ratio at a point where the atomic ratio of an element turns from increase to decrease or at a point where the atomic ratio of an element turns from decrease to increase when the distance from the surface of the inorganic thin film layer in the film thickness direction is changed. The extreme value can be determined, for example, based on atomic ratios measured at a plurality of measurement positions in the film thickness direction. The positions at which the atomic ratio is measured are set so that the interval in the film thickness direction is, for example, 20 nm or less. A position indicating an extreme value in the film thickness direction can be obtained by, for example, comparing measured results at three or more measurement positions different from one another for a discrete data group including measured results at each measurement position and then determining a position at which the measured result turns from increase to decrease or a position at which the measured result turns from decrease to increase. A position indicating an extreme value can also be obtained by, for example, differentiating an approximate curve determined from the above-described discrete data group. In a case where the length of a section where the atomic ratio is monotonically increased or decreased is, for example, 20 nm or more from the position of an extreme value, the absolute value of a difference between the extreme vale and the atomic ratio at a position moved by 20 nm in the film thickness direction from the position of an extreme value is, for example, 0.03 or more.

In the inorganic thin film layer formed so as to satisfy the condition that the carbon distribution curve has at least one extreme value, and more preferably eight or more extreme values as described above, the amount of increase in gas transmittance before and after the inorganic thin film layer is bent is smaller as compared with a case where the above condition is not satisfied. In other words, when the above condition is satisfied, an effect of suppressing deterioration in gas barrier properties caused by bending is obtained. When the thin film layer is formed so that the number of extreme values in the carbon distribution curve is two or more, the amount of increase in gas transmittance is smaller than a case where the number of extreme values in the carbon distribution curve is one. When the thin film layer is formed so that the number of extreme values in the carbon distribution curve is three or more, the amount of increase in gas transmittance is smaller than a case where the number of extreme values in the carbon distribution curve is two. When the carbon distribution curve has two or more extreme values, the absolute value of a difference between the distance from the surface of the thin film layer to a position indicating a first extreme value in the film thickness direction and the distance from the surface of the thin film layer to a position indicating a second extreme value adjacent to the first extreme value in the film thickness direction is preferably in a range of 1 nm or more and 200 nm or less, and more preferably in a range of 1 nm or more and 100 nm or less.

Further, the absolute value of a difference between the maximum value and the minimum value of the atomic ratio of carbon in the carbon distribution curve of the inorganic thin film layer is preferably more than 0.01. In the inorganic thin film layer formed as to satisfy the above-described condition, the amount of increase in gas transmittance before and after the inorganic thin film layer is bent is smaller as compared with a case where the above-described condition is not satisfied. In other words, when the above condition is satisfied, an effect of suppressing deterioration in gas barrier properties caused by bending is obtained. When the absolute value of a difference between the maximum value and the minimum value of the atomic ratio of carbon is 0.02 or more, the above-described effect is increased and when this absolute value is 0.03 or more, the effect is further increased.

There is a tendency that the gas barrier properties of the inorganic thin film layer are enhanced with decrease in the absolute value of a difference between the maximum value and the minimum value of the atomic ratio of silicon in the silicon distribution curve. From this point of view, the absolute value is preferably less than 0.05 (less than 5 at %), more preferably less than 0.04 (less than 4 at %), and particularly preferably less than 0.03 (less than 3 at %).

Further, when the sum of the atomic ratios of an oxygen atom and a carbon atom at each distance in the oxygen-carbon distribution curve is defined as "total atomic ratio", there is a tendency that the gas barrier properties of the thin film layer are enhanced with decrease in the absolute value of a difference between the maximum value and the minimum value of the total atomic ratio. From this point of view, the total atomic ratio is preferably less than 0.05, more preferably less than 0.04, and particularly preferably less than 0.03.

When the inorganic thin film layer is made to have substantially uniform composition in the inorganic thin film layer surface direction, the gas barrier properties of the inorganic thin film layer can be made to be uniform and enhanced. The substantially uniform composition means that, in the oxygen distribution curve, the carbon distribution curve, and the oxygen-carbon distribution curve, the numbers of extreme values existing in each of the film thickness directions at optional two points on the surface of the inorganic thin film layer are equal to each other, and the absolute values of differences between the maximum value and the minimum value of the atomic ratio of carbon in each carbon distribution curve are equal to each other or are different by 0.05 or less from each other.

The inorganic thin film layer formed so as to satisfy the above-described condition can exhibit the gas barrier properties required for, for example, flexible electronic devices including, for example, organic EL elements.

In a preferred embodiment of the present invention in which the inorganic thin film layer contains at least a silicon atom, an oxygen atom, and a carbon atom, an inorganic material layer containing such atoms is more preferably formed by a chemical vapor deposition method (CVD), in particular, a plasma chemical vapor deposition method (PECVD method) using, for example, a glow discharge plasma from the viewpoint of easily increasing denseness and reducing defects such as small gaps and cracks.

Examples of the raw material gas used in the chemical vapor deposition method include organic silicon compounds containing a silicon atom and a carbon atom. Examples of the organic silicon compound include hexamethyldisiloxane, 1,1,3,3-tetramethyldisiloxane, vinyltrimethylsilane, methyltrimethylsilane, hexamethyldisilane, methylsilane, dimethylsilane, trimethylsilane, diethylsilane, propylsilane, phenylsilane, vinyltriethoxysilane, vinyltrimethoxysilane, tetramethoxysilane, tetraethoxysilane, phenyltrimethoxysilane, methyltriethoxysilane, and octamethylcyclotetrasiloxane. Among these organic silicon compounds, hexamethyldisiloxane and 1,1,3,3-tetramethyldisiloxane are preferable from the viewpoint of handleability of the compound and characteristics such as gas barrier properties of an inorganic thin film layer to be obtained. As the raw material gas, one type of organic silicon compound may be used singly, or two or more types thereof may be used in combination.

Also, a reaction gas capable of reacting with the above-described raw material gas to form inorganic compounds such as oxides, and nitrides can be appropriately selected and mixed in the raw material gas. As the reaction gas for forming oxides, for example, oxygen and ozone can be used. Also, as the reaction gas for forming nitrides, for example, nitrogen and ammonia can be used. These reaction gases may be used either singly or in combinations of two or more types. In a case where, for example, an oxynitride is formed, a reaction gas for forming oxides and a reaction gas for forming nitrides can be used in combination. The flow ratio of the raw material gas and the reaction gas can be appropriately adjusted according to the atomic ratio of an inorganic material to be formed into a film.

To supply the raw material gas into the vacuum chamber, a carrier gas may also be used as necessary. Further, to generate plasma discharge, a discharge gas may also be used as necessary. As such a carrier gas and discharge gas, publicly known gases can be appropriately used. Examples thereof include rare gases such as helium, argon, neon, and xenon; and hydrogen.

Further, the pressure (degree of vacuum) in the vacuum chamber can be appropriately adjusted according to, for example, the type of raw material gas, and is preferably in a range of 0.5 Pa to 50 Pa.

[Protection layer]

The laminate film of the present invention may include a protection layer on a surface of the first inorganic thin film layer on a side opposite to the first organic layer. By providing the protection layer, a flexible electronic device including a laminate film and the laminate film can be protected from scratches, dirt, dusts, and the like. The laminate film of the present invention may also include a protection layer on a surface of the second inorganic thin film layer on a side opposite to the second organic layer.

From the viewpoint of securing adhesion to the first inorganic thin film layer, the protection layer is preferably a layer obtained by subjecting a coating film obtained from a coating solution containing a silicon compound to modification treatment.

Preferred examples of the silicon compound for forming the protection layer include polysiloxane compounds, polysilazane compounds, polysilane compounds, and mixtures thereof. In particular, inorganic silicon compounds such as hydrogenated silsesquioxane and perhydropolysilazane are preferred from the viewpoint of achieving both flexibility and surface hardness. Examples of the perhydropolysilazane include products such as AZ inorganic silazane coating material (NAX series, NL series, and NN series) available from Merck Performance Materials, Ltd.

Examples of the method of applying a coating solution containing a silicon compound in the formation of the protection layer include various types of application methods conventionally used such as spray coating, spin coating, bar coating, curtain coating, an immersion method, an air knife method, slide coating, hopper coating, reverse roller coating, gravure coating, and extrusion coating.

The thickness of the protection layer is appropriately set according to the purpose, and for example, in a range of 10 nm to 10 $\mu$m, and more preferably in a range of 100 nm to 1 $\mu$m. Further, the protection layer is preferably flat, and the average surface roughness obtained by observing the protection layer by a white light interferometric microscope is preferably 50 nm or less, and more preferably 10 nm or less. Note that the thickness of the protection layer can be measured by a film thickness meter.

In the formation of the protection layer, the film thickness can be adjusted to a desired film thickness by one application or can be adjusted to a desired film thickness by a plurality of applications. In the case of the plurality of applications, modification treatment is preferably performed in every application.

Examples of the method of subjecting a coating film to modification treatment in the formation of the protection layer include heat treatment, heat-moisture treatment, plasma treatment, ultraviolet irradiation treatment, excimer irradiation treatment (vacuum ultraviolet irradiation treatment), electron beam irradiation treatment, and ion implantation treatment. Excimer irradiation treatment, ion implantation treatment, or the like is preferable from the viewpoint of efficiently modifying the surface and/or inside of the coating film into silicon oxides or silicon oxynitrides at low temperatures.

[Other layers]

The laminate film of the present invention may include another layer between respective layers or in the outermost layer as long as the laminate film includes a second primer layer, a flexible substrate, a first primer layer, a first organic layer, and a first inorganic thin film layer in this order. Example of the other layer include the second inorganic thin film layer, the second organic layer, an easy-sliding layer, a hard coat layer, a transparent conductive layer, a color filter layer, an easy-adhesive layer, a curling control layer, a stress relaxation layer, a heat-resistant layer, a scratch-resistant layer, and an indentation-resistant layer.

[Layer structure]

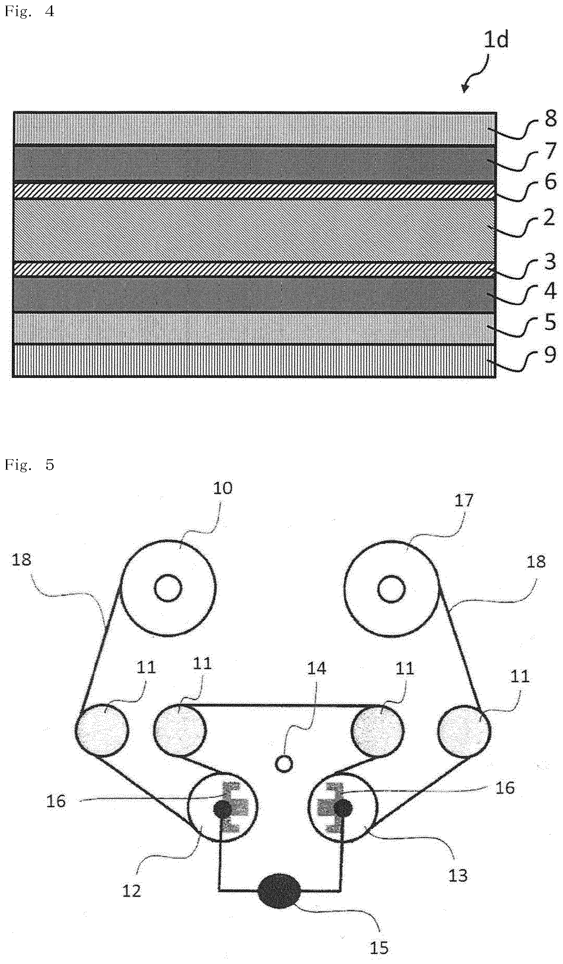

The layer structure of the laminate film of the present invention is not particularly limited as long as the laminate film includes a second primer layer, a flexible substrate, a first primer layer, a first organic layer, and a first inorganic thin film layer in this order. Specifically, the layer structure of the laminate film of the present invention may be a five-layer structure of second primer layer/flexible substrate/first primer layer/first organic layer/first inorganic thin film layer (structure shown in Fig. 1) or the like; a six-layer structure of second organic layer/second primer layer/flexible substrate/first primer layer/first organic layer/first inorganic thin film layer (structure shown in Fig. 2), second inorganic thin film layer/second primer layer/flexible substrate/first primer layer/first organic layer/first inorganic thin film layer or the like; a seven-layer structure of second inorganic thin film layer/second organic layer/second primer layer/flexible substrate/first primer layer/first organic layer/first inorganic thin film layer (structure shown in Fig. 3), second organic layer/second inorganic thin film layer/second primer layer/flexible substrate/first primer layer/first organic layer/first inorganic thin film layer or the like; an eight-layer structure of second inorganic thin film layer/second organic layer/second primer layer/flexible substrate/first primer layer/first organic layer/first inorganic thin film layer/protection layer (structure shown in Fig. 4), or the like; and a nine or more-layer structure of second protection layer/second inorganic thin film layer/second organic layer/second primer layer/flexible substrate/first primer layer/first organic layer/first inorganic thin film layer/first protection layer, or the like. Note that each layer in the layer structure of the laminate film of the present invention may be a monolayer or a multilayer. Further, in a case where the layer structure of the present invention includes two or more flexible substrates, the two or more flexible substrates may be the same layers or layers which are different from one another. The case of including two or more organic layers, or two or more inorganic thin film layers is the same. The above-described specific layer structure may further include the above-described other layers.

[First embodiment]

In a preferred first embodiment, the laminate film of the present invention includes at least a second primer layer/flexible substrate/first primer layer/first organic layer/first inorganic thin film layer (structure shown in Fig.1). In the present embodiment, the first organic layer may be a layer having a function as a planarization layer, or a layer having a function as an antiblocking layer, but is preferably a planarization layer. In the present embodiment, the second primer layer functions as a protection layer of the laminate film and also functions as enhancing slipping in the production and preventing blocking.

[Second embodiment]

In a preferred second embodiment, the laminate film of the present invention includes at least a second organic layer/second primer layer/flexible substrate/first primer layer/first organic layer/first inorganic thin film layer (structure shown in Fig. 2). In the present embodiment, the first organic layer and the second organic layer may each be a layer having a function as a planarization layer, or a layer having a function as an antiblocking layer. It is preferred that the first organic layer be a planarization layer and the second organic layer be an antiblocking layer. The first inorganic thin film layer may be a layer having a function as a gas barrier layer, or a layer having a function as a warpage control layer, but is preferably at least a layer having a function as a gas barrier layer. The first organic layer and the second organic layer may each be the same layers, or may be layers that are different from each other in the composition, the number of layers, or the like.

[Third embodiment]

In a preferred third embodiment, the laminate film of the present invention includes at least a second inorganic thin film layer/second organic layer/second primer layer/flexible substrate/first primer layer/first organic layer/first inorganic thin film layer (structure shown in Fig. 3). The layer structure of the present embodiment is a layer structure including a second inorganic thin film layer on a surface of the second organic layer on a side opposite to the second primer layer in the layer structure of the second embodiment. The first inorganic thin film layer and the second inorganic thin film layer may each be a layer having a function as a gas barrier layer, or a layer having a function as a warpage control layer. It is preferred that the first inorganic thin film layer be at least a layer having a function as a gas barrier layer, and the second inorganic thin film layer be a layer having a function as a warpage control layer. The first inorganic thin film layer and the second inorganic thin film layer may each be the same layers, or may be layers that are different from each other in the composition, the number of layers or the like.

[Fourth embodiment]

In a preferred fourth embodiment, the laminate film of the present invention includes at least a second inorganic thin film layer/second organic layer/second primer layer/flexible substrate/first primer layer/first organic layer/first inorganic thin film layer/protection layer (structure shown in Fig. 4). The layer structure of the present embodiment is a layer structure including a protection layer on a surface of the first inorganic thin film layer on a side opposite to the first organic layer in the layer structure of the third embodiment. By providing the protection layer, a flexible electronic device including a laminate film and the laminate film can be protected from scratches, dirt, dusts, and the like.

[Production method of laminate film]

The production method of the laminate film of the present invention is not particularly limited as long as each layer can be formed in the above-described order. Example thereof include a method of forming a first primer layer on one surface of a flexible substrate and a second primer layer on the other surface of the flexible substrate, forming a first organic layer on the first primer layer, and then forming a first inorganic thin film layer on the first organic layer. Further, the laminate film of the third embodiment can be produced by, for example, further forming a second organic layer on the second primer layer and then forming a second inorganic thin film layer on the second organic layer. Note that the laminate film of the present invention may also be produced by separately fabricating each layer and then adhering to the layer.

From the viewpoint of easily enhancing the denseness of the inorganic thin film layer and reducing defects such as small gaps and cracks, the laminate film of the present invention is preferably produced by forming the thin film layer on the organic thin film layer by using a glow discharge plasma by a publicly known vacuum film formation method such as a CVD method as described above. The inorganic thin film layer is preferably formed in the continuous film forming process, and more preferably, continuously formed on a long laminate while conveying the laminate continuously, for example. Specifically, an inorganic thin film layer may be formed while conveying the laminate from a feed roll to a winding roll. After the formation of the above thin film layer, an inorganic thin film layer may be further formed by inverting the feed roll and the winding roll to convey the laminate in the reverse direction.

[Flexible electronic device]

The present invention encompasses a flexible electronic device including the laminate film of the present invention. Examples of the flexible electronic device (flexible display) include liquid crystal display elements, solar cells, organic EL displays, organic EL microdisplays, organic EL lighting devices, and electronic papers that require high gas barrier properties. The laminate film of the present invention is preferably used as a flexible substrate for flexible electronic devices. In a case where the laminate film is used as a flexible substrate, a device may be formed directly on the laminate film, or the laminate film may be laminated on a device with an adhesive layer or a pressure-sensitive adhesive layer interposed therebetween after the device is formed on a separate substrate. Note that the laminate film and the device may be stacked so that the device side and the outermost surface of the laminate film on a side of the second primer layer side face each other, but is preferably stacked so that the device side and the outermost surface of the laminate film on a side of the first primer layer face each other.

EXAMPLES

Hereinafter, the present invention will be described in more detail with reference to Examples. Unless otherwise indicated, the notations of "%" and "part" in Examples are mass% and part by mass respectively.

The apparatus, measurement method, and evaluation method used in Examples are as described below.

[Film thickness]

The film thickness of each of the primer layer, the organic layer, the inorganic thin film layer, and the protection layer of the laminate films obtained in Examples and Comparative Examples was determined by measuring a step difference between a non-film forming part and a film forming part by a film thickness meter (Surfcorder ET200, available from Kosaka Laboratory Ltd.).

[Thermal linear expansion measurement of laminate film]

Evaluation of thermal linear expansion measurement of the laminate films obtained in Examples and Comparative Examples was performed using a thermal mechanical analyzer "TMA 7100A", available from Hitachi High-Tech Science Corporation. Specifically, each of the laminate films was cut out into a rectangular shape with a length of about 20 mm and a width of 5 mm, and the thermal linear expansion displacement in the tensile mode was measured under the conditions at a tensile load of 29.4 mN and a temperature elevation rate of 20°C/min. When the thermal linear expansion displacement in the MD is defined as A ($\mu$m), and the heating temperature is defined as T (°C), dA/dT where T is 50 to 200°C, that is, the amount of change in A relative to the amount of increase in T was measured. The case where the amount of change in A in the above-described temperature range was constantly positive was evaluated as "+", the case where the amount of change in A included zero or negative was evaluated as "+/-", and the case where the amount of change in A was constantly negative was evaluated as "-".

[Thermal dimensional change rate measurement of laminate film]

Each of the laminate films obtained in Examples and Comparative Examples was cut out into a A4 size (MD of the laminate film is taken as the long side and TD in the laminate film is taken as the short side). Then, a square was marked at the center of the laminate film so that the length in the MD is 200 mm and the length in the TD is 200 mm, and the lengths of four sides of the square were measured with a caliper (minimum graduation: 0.05 mm). Thereafter, the laminate film was placed on a SUS plate at 25°C, and the SUS plate and the laminate film were placed in a hot-air circulating oven heated at 200°C. After the elapse of 20 minutes under the condition at 200°C, the laminate film was taken out from the oven and cooled to 25°C. Then, the four sides of the marked square were measured again with the caliper. When the length of one side of the square before heating is defined as L0, and the length of the same one side of the square after heating is defined as L1, the dimensional change rate was calculated from $((L1 - L0)/L0) \times 100$ (dimensional change rate in the case of expansion was defined as positive and dimensional change rate in the case of shrinkage was defined as negative). Here, the dimensional change rate in the MD means a value obtained by calculating the dimensional change rates for two sides in the MD of the square drawn on the laminate film and averaging the calculated dimensional change rates for the two sides. Further, the dimensional change rate in the TD means a value obtained by calculating the dimensional change rates for two sides in the TD of the square drawn on the laminate film and averaging the calculated dimensional change rates for the two sides.

[Heat resistance evaluation of laminate film]

A glass plate (EAGLE XG grade, available from Corning Incorporated, thickness: 0.7 mm), a heat-resistant adhesive sheet (thickness: 0.025 mm), and each of the laminate films obtained in Examples and Comparative Examples were each cut out into a square of 50 mm $\times$ 50 mm, and the glass plate, the heat-resistant adhesive sheet, and the laminate film were laminated in this order with a hand roller to produce a test piece. The lamination of the laminate film was made so that the first inorganic thin film layer or the protection layer was disposed on the surface side (a side opposite to the heat-resistant adhesive sheet). The test piece was placed on a heating stage at 200°C so that the glass plate faces downward and heated for 30 minutes. Then, the test piece was taken out from the heating stage and then cooled to 25°C, and generation of cracks on the surface of the laminate film was observed. The case where no cracks occur in the surface of the laminate film excluding a portion 1 mm or less inward from four sides of the laminate film was evaluated as "o", and the case where cracks occur was evaluated as "$\times$".

[Warpage stability of laminate film]

Each of the laminate films was cut out into a square with a size of 50 mm in the MD and 50 mm in the TD at 25°C, and the heights at four corners of the square were measured with a ruler with a graduation of 0.5 mm to measure the average height (H0) of the four corners. Subsequently, the laminate film was placed on a SUS plate and the SUS plate and the laminate film were placed in a hot-air circulating oven heated at 200°C. After the elapse of 30 minutes, the laminate film was taken out from the oven and cooled to 25°C. Then, the average height (H1) of the four corners of the square was measured in a manner similar to the above. The warpage stability before and after heating was calculated based on $|H1 - H0|$(mm).

[Dehydration amount measurement of laminate film]

Evaluation of the amount of dehydration in the surface of the laminate film when each of the laminate films obtained in Examples and Comparative Examples was heated at 150°C was performed using a vaporizing system Karl-Fischer device 831 KF Coulometer and 832 KF Thermoprep, available from Metrohm AG.

[Water vapor transmission rate of laminate film]

The water vapor transmission rate was measured under the conditions at a temperature of 23°C and a humidity of 50%RH in accordance with ISO/WD 15106-7 (Annex C) by a Ca corrosion test method.

[Optical characteristics of laminate film]

(Total light transmittance and haze)

The total light transmittance and the haze of the laminate films obtained in Examples and Comparative Examples were measured by a direct-reading haze computer (model: HGM-2DP) available from Suga Test Instruments Co., Ltd. After background measurement was carried out in a state free from the laminate film, the laminate film was set to a sample holder and measurement was carried out, thus determining the total light transmittance and the haze of the laminate film.

[X-Ray photoelectron spectroscopic measurement of inorganic thin film layer in thickness direction]

The atomic number ratio profile in the thickness direction of the inorganic thin film layer of the laminate films obtained in Examples and Comparative Examples was measured by X-ray photoelectron spectrometry. AlK$\alpha$ rays were used as the X-ray source and a neutralization electron gun and a slow Ar ion gun were used for electrification correction in the measurement. In the analysis after measurement, spectrum analysis was performed using MultiPak V6.1A (available from ULVAC-PHI, Inc.) to calculate the surface atomic number ratio (C/Si) of C to Si and the surface atomic number ratio (O/Si) of O to Si by using peaks each corresponding to each binding energy of 2p of Si, 1s of O, 1s of N, and 1s of C obtained from the measured wide scan spectra. As the surface atomic number ratio, the average of five measured values was used. The carbon distribution curve was created from the result.

<XPS depth profile measurement condition>

Etching ion species: Argon (Ar$^+$)
Etching rate (conversion value in terms of $SiO_2$ thermal oxide film): 0.027 nm/sec
Sputtering time: 0.5 minutes
X-ray photoelectron spectroscopic apparatus: (Model name: "Quantera SXM", available from ULVAC-PHI, Inc.)
X-rays to be irradiated: single crystal spectrum AlK$\alpha$ (1486.6 eV)
X-ray spot and size: 100 $\mu$m
Detector: Pass Energy 69 eV, Step size 0.125 eV
Electrification correction: neutralization electron gun (1 eV), slow Ar ion gun (10V)

[Production method of inorganic thin film layer]

In Examples and Comparative Examples, an inorganic thin film layer was laminated on an organic layer laminated on a flexible substrate having primer layers on both surfaces thereof by using a production apparatus shown in Fig. 5. Specifically, as shown in Fig. 5, the flexible substrate, on which the organic layer has been laminated, was mounted on a feed roll 10. Magnetic field was applied between a film forming roll 12 and a film forming roll 13 and electric power was supplied to the film forming roll 12 and the film forming roll 13 to generate plasma between the film forming roll 12 and the film forming roll 13 by discharge. A film forming gas (mixed gas of hexamethyldisiloxane (HMDSO) as a raw material gas and oxygen gas as a reaction gas (also functions as a discharge gas)) was supplied to such a discharge region to form a thin film under the following film formation conditions by a plasma CVD method, thus laminating an inorganic thin film layer on the organic layer laminated on the flexible substrate having primer layers on both surfaces thereof. Note that, for the degree of vacuum in the vacuum chamber in the following film formation condition, a value obtained by detecting the pressure around the discharge port with a diaphragm vacuum gauge was used.

<Film formation condition 1>

Supply amount of raw material gas: 50 sccm (standard cubic centimeter per minute)
Supply amount of oxygen gas: 500 sccm
Degree of vacuum inside the vacuum chamber: 1 Pa
Electric power application from the power source for plasma generation : 0.8 kW
Frequency of the power source for plasma generation : 70 kHz
Film conveying speed: 0.6 m/min
Number of passes: 4 times

[Production method of organic layer]

In Examples and Comparative Examples, TOMAX (registered trademark) FA-3292 (referred to as "organic layer forming composition 1") available from Nippon Kako Toryo Co., Ltd. was used as an organic layer forming composition for forming the first organic layer. The organic layer forming composition 1 is a composition containing 8.1 mass% of ethyl acetate, 52.1 mass% of propylene glycol monomethyl ether, as a solvent; 10 to 20 mass% of UV curable oligomers, 20 to 30 mass% of silica particles (average primary particle size: 20 nm) as a solid content; and 2 to 3 mass% of a photopolymerization initiator as an additive. The UV curable oligomer is a photocurable compound having a (meth)acryloyl group as a polymerizable functional group. As an organic layer forming composition for forming the second organic layer, a composition obtained by adding 8 mass% of silica particles having an average primary particle size of 50 nm to the organic layer forming composition 1 (referred to as "organic layer forming composition 2) was used.

The organic layer forming composition 1 and the organic layer forming composition 2 were applied to a flexible substrate having primer layers on both surfaces thereof by a gravure coating method while conveying the flexible substrate at a speed of 10 m/min. The flexible substrate was then passed through a drying furnace at 100°C for 30 seconds or more to evaporate the solvent, after which UV rays were irradiated to cure the organic layer forming composition 1, thus producing an organic layer (UV curing condition: electrodeless UV lamp, available from Fusion UV Systems, Inc., 200 mJ/cm$^2$).

[Example 1]

In accordance with the production method of an organic layer, a first organic layer A1 with a film thickness of 2.5 $\mu$m was laminated on one surface of a polyethylene naphthalate film which is a flexible substrate having primer layers on both surfaces thereof (PEN film, thickness: 100 $\mu$m, width: 700 mm, trade name "TEONEX (registered trademark)", Q65HWA, available from Teijin Film Solutions, Tg: 160°C, including primer layers having a softening point of 180°C or higher and a film thickness of 100 nm (containing polyester resin as a main component and also silica particles) on both surfaces, and subjected to annealing treatment). Subsequently, a first inorganic thin film layer A1 with a film thickness of 750 nm was laminated on a surface of the first organic layer A1 side in accordance with the production method of an inorganic thin film layer. Also, a second organic layer B1 with a film thickness of 1.5 $\mu$m was laminated on the other surface of the flexible substrate in accordance with the production method of an organic layer. Further, a second inorganic thin film layer B1 with a film thickness of 700 nm was laminated on a surface of the second organic layer B1 in the same manner as the production method of an inorganic thin film layer except that the degree of vacuum in the vacuum chamber was 5 Pa, the conveying speed and the number of passes were slightly adjusted. Thus, a laminate film 1 was obtained.

The laminate film 1 obtained in Example 1 includes a layer structure of second inorganic thin film layer Bl/second organic layer Bl/second primer layer/flexible substrate/first primer layer/first organic layer A1 (planarization layer)/first inorganic thin film layer A1.

The obtained laminate film 1 has a water vapor transmission rate of $1 \times 10^{-6}$ g/m$^2$/day, a total light transmittance of 90%, and a haze of 0.7%. Also, from the result of XPS depth profile measurement, it was found that the atomic number ratio of carbon atoms to the total number of silicon atoms, oxygen atoms, and carbon atoms contained in the inorganic thin film layer continuously varied in 90% or more of an area in the film thickness direction of the inorganic thin film layer; the atomic number ratios of oxygen, silicon, and carbon were decreased in this order; and the carbon distribution curve in the film thickness direction had 30 or more extreme values.

In the obtained laminate film 1, the warpage stability before and after heating was |H1 - H0| = 14 mm, and the amount of dehydration in the surface of the laminate film heated at 150°C was 0.28%.

[Example 2]

In accordance with the production method of an organic layer, a first organic layer A2 with a film thickness of 0.8 $\mu$m was laminated on one surface of a polyethylene naphthalate film which is a flexible substrate having primer layers on both surfaces thereof (PEN film, thickness: 100 $\mu$m, width: 700 mm, trade name "TEONEX (registered trademark)", available from Teijin Film Solutions, Tg: 160°C, including primer layers having a softening point of 180°C or higher and a film thickness of 100 nm (containing polyester resin as a main component and also silica particles) on both surfaces, and subjected to annealing treatment). Subsequently, a first inorganic thin film layer A1 with a film thickness of 750 nm was laminated on a surface of the first organic layer A2 side in accordance with the production method of an inorganic thin film layer. Also, a second organic layer B2 with a film thickness of 1.2 $\mu$m was laminated on the other surface of the flexible substrate in accordance with the production method of an organic layer. Further, a second inorganic thin film layer B1 with a film thickness of 700 nm was laminated on a surface of the second organic layer B2 in the same manner as the production method of an inorganic thin film layer except that the degree of vacuum in the vacuum chamber was 5 Pa, the conveying speed and the number of passes were slightly adjusted. Thus, a laminate film 2 was obtained.

The laminate film 2 obtained in Example 2 includes a layer structure of second inorganic thin film layer Bl/second organic layer B2/second primer layer/flexible substrate/first primer layer/first organic layer A2 (planarization layer)/first inorganic thin film layer A1.

The obtained laminate film 2 has a water vapor transmission rate of $3 \times 10^{-6}$ g/m$^2$/day, a total light transmittance of 90%, and a haze of 0.6%. Also, from the result of XPS depth profile measurement, it was found that the atomic number ratio of carbon atoms to the total number of silicon atoms, oxygen atoms, and carbon atoms contained in the inorganic thin film layer continuously varied in 90% or more of an area in the film thickness direction of the inorganic thin film layer;

the atomic number ratios of oxygen, silicon, and carbon were decreased in this order; and the carbon distribution curve in the film thickness direction had 15 or more extreme values.

In the obtained laminate film 2, the warpage stability before and after heating was |H1 - H0| = 10 mm, and the amount of dehydration in the surface of the laminate film heated at 150°C was 0.28%.

[Example 3]

A polysilazane (PHPS) solution ("Grade NAX120" available from Merck Performance Materials, Ltd., containing 80 mass% of xylene and 20 mass %of polysilazane) as a coating solution containing a silicon compound was applied to a surface of the first inorganic thin film layer A1 on a side opposite to the first organic layer A1 in the laminate film 1 obtained in Example 1 by a gravure coating method, and the coating was dried at 130°C to form a protection layer A1 with a film thickness of 500 nm, thus obtaining a laminate film 3.

The laminate film 3 obtained in Example 3 includes a layer structure of second inorganic thin film layer BI/second organic layer BI/second primer layer/flexible substrate/first primer layer/first organic layer A1 (planarization layer)/first inorganic thin film layer A1/protection layer A1.

The obtained laminate film 3 has a water vapor transmission rate of $<1 \times 10^{-6} g/m^2/day$, a total light transmittance of 90%, and a haze of 0.7%. Also, from the result of XPS depth profile measurement, it was found that the atomic number ratio of carbon atoms to the total number of silicon atoms, oxygen atoms, and carbon atoms contained in the inorganic thin film layer continuously varied in 90% or more of an area in the film thickness direction of the inorganic thin film layer; the atomic number ratios of oxygen, silicon, and carbon were decreased in this order; and the carbon distribution curve in the film thickness direction had 30 or more extreme values.

In the obtained laminate film 3, the warpage stability before and after heating was |H1 - H0| = 6 mm, and the amount of dehydration in the surface of the laminate film heated at 150°C was 0.29%.

[Example 4]

A laminate film 4 was obtained in the same manner as in Example 1 except that a polyethylene naphthalate film was used as a flexible substrate having primer layers on both surfaces thereof (PEN film, thickness: 100 $\mu$m, width: 700 mm, trade name "TEONEX (registered trademark)", Q65HW (grade), available from Teijin Film Solutions, Tg: 160°C, including primer layers having a softening point of 180°C or higher and a film thickness of 100 nm (containing polyester resin as a main component and also silica particles) on both surfaces, and no annealing treatment).

The laminate film 4 obtained in Example 4 includes a layer structure of second inorganic thin film layer BI/second organic layer BI/second primer layer/flexible substrate/first primer layer/first organic layer A1 (planarization layer)/first inorganic thin film layer A1.

The obtained laminate film 4 has a water vapor transmission rate of $2 \times 10^{-6} g/m^2/day$, a total light transmittance of 90%, and a haze of 0.7%.

[Example 5]

A laminate film 5 was obtained in the same manner as in Example 4 except that the first organic layer A2 and the second organic layer B2 were used in place of the first organic layer A1 and the second organic layer B1.

The laminate film 5 obtained in Example 5 includes a layer structure of second inorganic thin film layer BI/second organic layer BI/second primer layer/flexible substrate/first primer layer/first organic layer A2 (planarization layer)/first inorganic thin film layer A2.

The obtained laminate film 5 has a water vapor transmission rate of $3 \times 10^{-6} g/m^2/day$, a total light transmittance of 90%, and a haze of 0.6%.

[Comparative Example 1]

In accordance with the production method of an inorganic thin film layer, a first inorganic thin film layer A2 with a film thickness of 400 nm was laminated on one surface of a polyethylene naphthalate film which is a flexible substrate having primer layers on both surfaces thereof (PEN film, thickness: 100 $\mu$m, width: 700 mm, trade name "TEONEX (registered trademark)", Q65HW, available from Teijin Film Solutions, Tg: 130°C, including primer layers having a softening point of 180°C or higher and a film thickness of 100 nm (containing polyester resin as a main component and also silica particles) on both surfaces, and no annealing treatment). Further, a second inorganic thin film layer B2 with a film thickness of 400 nm was laminated on the other surface of the flexible substrate in the same manner as the production method of an inorganic thin film layer except that the degree of vacuum in the vacuum chamber was 5 Pa, the conveying speed and the number of passes were slightly adjusted. Thus, a laminate film 6 was obtained.

The laminate film 6 obtained in Comparative Example 1 includes a layer structure of second inorganic thin film layer B2/second primer layer/flexible substrate/first primer layer/first inorganic thin film layer A2.

[Comparative Example 2]

In accordance with the production method of an organic layer, a first organic layer A2 with a film thickness of 0.8 μm was laminated on one surface of a polyethylene terephthalate film which is a flexible substrate having primer layers on both surfaces thereof (PET film, thickness: 100 μm, width: 700 mm, trade name "COSMOSHINE (registered trademark) A4300", available from Toyobo Co., Ltd.", including silica particle-containing primer layers having a softening point of 180°C or higher and a film thickness of 100 nm on both surfaces). Subsequently, a first inorganic thin film layer A1 with a film thickness of 750 nm was laminated on a surface of the first organic layer A2 side in accordance with the production method of an inorganic thin film layer. Also, a second organic layer B2 with a film thickness of 1.2 μm was laminated on the other surface of the flexible substrate in accordance with the production method of an organic layer. Further, a second inorganic thin film layer B1 with a film thickness of 700 nm was laminated on a surface of the second organic layer B2 in the same manner as the production method of an inorganic thin film layer except that the degree of vacuum in the vacuum chamber was 5 Pa, the conveying speed and the number of passes were slightly adjusted. Thus, a laminate film 7 was obtained.

The laminate film 7 obtained in Comparative Example 2 includes a layer structure of second inorganic thin film layer Bl/second organic layer B2/second primer layer/flexible substrate/first primer layer/first organic layer A2 (planarization layer)/first inorganic thin film layer A1.

For the laminate films 1 to 7 obtained in Examples 1 to 5 and Comparative Examples 1 and 2, the thermal linear expansion measurement, thermal dimensional change rate measurement, and heat resistance evaluation were performed in accordance with the above-described measurement methods. The results are shown in Table 1. Note that for Comparative Example 1, since cracks occurred in the laminate film in the process of measuring thermal dimensional change rate, the dimensional change rates in the MD and in the TD could not be measured.

[Table 1]

| | Flexible substrate | | Second inorganic thin film layer | Second organic layer | First organic layer | First inorganic thin film layer | Protection layer | dA/dT | Dimensional change rate (%) | | Heat resistance evaluation |
|---|---|---|---|---|---|---|---|---|---|---|---|
| | Material | Annealing (treated or non-treated) | | | | | | | (MD) | (TD) | |
| Example 1 | PEN | Treated | B1 | B1 | A1 | A1 | - | + | 0.1 | 0.2 | ○ |
| Example 2 | PEN | Treated | B1 | B2 | A2 | A1 | - | + | 0. 3 | 0.4 | ○ |
| Example 3 | PEN | Treated | B1 | B1 | A1 | A1 | A1 | + | -0.1 | 0. 0 | ○ |
| Example 4 | PEN | Non-treated | B1 | B1 | A1 | A1 | - | + | -0.1 | 0.1 | ○ |
| Example 5 | PEN | Non-treated | B1 | B2 | A2 | A1 | - | + | 0. 1 | 0.2 | ○ |
| Comparative Example 1 | PEN | Non-treated | B2 | - | - | A2 | - | + | Fail to evaluate due to crack generation | | × |
| Comparative Example 2 | PET | Treated | B1 | B2 | A2 | A1 | - | +/- | -0.4 | 0.2 | × |

As shown in Table 1, the laminate films obtained in Examples 1 to 5 constantly satisfy the relationship dA/dT > 0 and have a dimensional change rate in the MD of -0.3 to 0.5%, and thus is excellent in heat resistance. On the contrary, the laminate film obtained in Comparative Example 1 does not include the first organic layer and the second organic layer, and the dimensional change rate in the MD does not satisfy -0.3 to 0.5%, and therefore heat resistance is inferior. The laminate film obtained in Comparative Example 2 does not constantly satisfy the relationship dA/dT > 0, the dimensional change rate in the MD does not fall within a range of -0.3 to 0.5%, and therefore heat resistance is inferior.

DESCRIPTION OF REFERENCE SIGNS

| | |
|---|---|
| 1a, 1b, 1c, 1d | Laminate film |
| 2 | Flexible substrate |
| 3 | First primer layer |
| 4 | First organic layer |
| 5 | First inorganic thin film layer |
| 6 | Second primer layer |
| 7 | Second organic layer |
| 8 | Second inorganic thin film layer |
| 9 | Protection layer |
| 10 | Feed roll |
| 11 | Conveying roll |
| 12 | Film forming roll |
| 13 | Film forming roll |
| 14 | Gas supply tube |
| 15 | Plasma generation power source |
| 16 | Magnetic field-generating apparatus |
| 17 | Winding roll |
| 18 | Film |

**Claims**

1.  A laminate film, comprising: a second primer layer, a flexible substrate, a first primer layer, a first organic layer, and a first inorganic thin film layer in this order, wherein
    the first primer layer and the second primer layer each have a softening temperature of 130°C or higher;
    when a thermal expansion displacement in an MD is defined as A ($\mu$m) and a heating temperature is defined as T (°C) when the laminate film is heated while being pulled at a tensile load of 29.4 mN and a temperature elevation rate of 20°C/min,
    the laminate film constantly satisfies a relationship dA/dT > 0 where T is 50 to 200°C; and
    a dimensional change rate in the MD when the laminate film is heated from 25°C to 200°C, left to stand at 200°C for 20 minutes, and cooled to 25°C is -0.3 to 0.5%.

2. The laminate film according to claim 1, wherein a dimensional change rate in a TD when the laminate film is heated from 25°C to 200°C, left to stand at 200°C for 20 minutes, and cooled to 25°C is 0 to 0.5%.

3. The laminate film according to claim 1 or 2, wherein a thickness of each of the first primer layer and the second primer layer is 1 μm or less.

4. The laminate film according to any of claims 1 to 3, wherein the first primer layer and/or the second primer layer contain silica particles.

5. The laminate film according to any of claims 1 to 4, wherein the first organic layer contains a polymerization product of a photocurable compound having a polymerizable functional group.

6. The laminate film according to any of claims 1 to 5, wherein the first inorganic thin film layer at least contains a silicon atom, an oxygen atom, and a carbon atom.

7. The laminate film according to any of claims 1 to 6, wherein an atomic number ratio of carbon atoms to a total number of silicon atoms, oxygen atoms, and carbon atoms contained in the first inorganic thin film layer continuously varies in 90% or more of an area of the first inorganic thin film layer in a film thickness direction of the first inorganic thin film layer.

8. The laminate film according to any of claims 1 to 7, wherein a carbon distribution curve has eight or more extreme values, the carbon distribution curve indicating a relationship between a distance from a surface of the first inorganic thin film layer in the film thickness direction of the first inorganic thin film layer and an atomic number ratio of carbon to the total number of silicon atoms, oxygen atoms, and carbon atoms contained in the first inorganic thin film layer at each distance.

9. The laminate film according to any of claims 1 to 8, further comprising a protection layer on a surface of the first inorganic thin film layer on a side opposite to the first organic layer.

10. The laminate film according to claim 9, wherein the protection layer is a layer obtained by subjecting a coating film obtained from a coating solution containing a silicon compound to modification treatment.

11. The laminate film according to any of claims 1 to 10, further comprising a second organic layer on a surface of the second primer layer on a side opposite to the flexible substrate.

12. The laminate film according to claim 11, wherein the second organic layer is an antiblocking layer.

13. The laminate film according to claim 11 or 12, further comprising a second inorganic thin film layer on a surface of the second organic layer on a side opposite to the second primer layer.

14. A flexible electronic device, comprising the laminate film according to any of claims 1 to 13.

Fig. 1

1a

6
2
3
4
5

Fig. 2

1b

7
6
2
3
4
5

Fig. 3

1c

8
7
6
2
3
4
5

Fig. 4

Fig. 5

## INTERNATIONAL SEARCH REPORT

| International application No. |
| --- |
| PCT/JP2019/012052 |

| A. CLASSIFICATION OF SUBJECT MATTER |
| --- |
| Int. Cl. B32B9/00(2006.01)i, B32B27/20(2006.01)i, H01L51/50(2006.01)i, H05B33/02(2006.01)i, H05B33/04(2006.01)i |

According to International Patent Classification (IPC) or to both national classification and IPC

| B. FIELDS SEARCHED |
| --- |
| Minimum documentation searched (classification system followed by classification symbols) |
| Int. Cl. B32B1/00-43/00, H01L51/50, H05B33/02, H05B33/04 |

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| A | JP 2015-186922 A (KONICA MINOLTA, INC.) 29 October 2015, claims, paragraphs [0021], [0027], [0028], [0039]-[0043], [0066]-[0070], [0184], [0185], [0306]-[0310] (Family: none) | 1-14 |
| A | JP 2006-44231 A (DAINIPPON PRINTING CO., LTD.) 16 February 2006, claims, paragraphs [0007], [0009], [0012]-[0015], [0023]-[0025], examples & US 2006/0093758 A1, claims, paragraphs [0014], [0032], [0050]-[0057], [0066]-[0068], examples | 1-14 |

☒ Further documents are listed in the continuation of Box C.   ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 05.06.2019 | 18.06.2019 |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2019/012052

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2010-7090 A (DUPONT TEIJIN FILMS U.S. LIMITED PARTNERSHIP) 14 January 2010, claims, paragraphs [0018], [0033], [0048], [0049], [0057] & JP 2005-522561 A & US 2005/0238871 A1 & US 2010/0154886 A1, claims, paragraphs [0010], [0032], [0047], [0048] & US 2010/0159198 A1 & WO 2003/087247 A1 & CN 1659248 A & KR 10-2004-0108724 A | 1-14 |
| A | JP 2010-184409 A (TOPPAN PRINTING CO., LTD.) 26 August 2010, claims, paragraphs [0023], [0024], example 1 (Family: none) | 1-14 |
| A | JP 2011-238355 A (KONICA MINOLTA HOLDINGS, INC.) 24 November 2011, claims, paragraph [0202] (Family: none) | 1-14 |
| A | JP 2016-22589 A (KONICA MINOLTA, INC.) 08 February 2016, claims, paragraphs [0015], [0021], [0173], [0174], examples 1-1 (Family: none) | 1-14 |
| A | JP 2015-47823 A (JNC CORP.) 16 March 2015, claims, paragraphs [0038], [0039], [0042], [0057], [0073], [0074], [0078], example 5 & WO 2015/033850 A1 & TW 201511944 A | 1-14 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016068383 A